(19) **Europäisches Patentamt**
**European Patent Office**
**Office européen des brevets**

(11) **EP 4 394 509 A1**

(12) **EUROPEAN PATENT APPLICATION**
published in accordance with Art. 153(4) EPC

(43) Date of publication:
**03.07.2024 Bulletin 2024/27**

(21) Application number: **22861216.4**

(22) Date of filing: **17.08.2022**

(51) International Patent Classification (IPC):
*G03F 7/033* (2006.01)    *B41N 1/12* (2006.01)
*C08F 297/04* (2006.01)    *G03F 7/00* (2006.01)
*G03F 7/075* (2006.01)

(52) Cooperative Patent Classification (CPC):
**B41N 1/12; C08F 297/04; G03F 7/00; G03F 7/033;
G03F 7/075**

(86) International application number:
**PCT/JP2022/031104**

(87) International publication number:
**WO 2023/026928 (02.03.2023 Gazette 2023/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **25.08.2021 JP 2021137237**

(71) Applicant: **Zeon Corporation
Tokyo 100-8246 (JP)**

(72) Inventor: **NOZAWA, Atsushi
Tokyo 100-8246 (JP)**

(74) Representative: **Kraus & Lederer PartGmbB
Thomas-Wimmer-Ring 15
80539 München (DE)**

(54) **PHOTOSENSITIVE COMPOSITION FOR PATTERN FORMATION, AND FLEXOGRAPHIC PLATE**

(57) Provided is a photosensitive composition for pattern formation which can provide a molded body having high photosensitivity, sufficient wear resistance, and high flexibility and high ink swelling resistance. Provided is a photosensitive composition for pattern formation comprising a block copolymer composition and a photopolymerization initiator, wherein the block copolymer composition contains a block copolymer A1 represented by specific General Formula (1) or a block copolymer A2 represented by specific General Formula (2), and the weight average molecular weight (Mw) of the entire block copolymer composition is 300,000 to 800,000.

EP 4 394 509 A1

**Description**

TECHNICAL FIELD

The present invention relates to a photosensitive composition for pattern formation, and a flexographic plate formed from the photosensitive composition for pattern formation.

BACKGROUND ART

Flexographic printing is widely used as a printing method for labels, plastic containers, cartons, plastic bags, boxes, envelops, and the like. Flexographic plates frequently used in this flexographic printing are those formed by exposing photosensitive compositions for pattern formation to light, each photosensitive composition comprising an elastomer, a polymerizable ethylenically unsaturated monomer, and a photopolymerization initiator.

As the elastomer used to constitute a composition for a photosensitive flexographic plate, thermoplastic elastomers having high processability are widely used. Among these, aromatic vinyl-conjugated diene-aromatic vinyl block copolymers such as styrene-isoprene-styrene block copolymer (SIS) and styrene-butadiene-styrene block copolymer (SBS) are positively used as the elastomer to constitute the composition for a photosensitive flexographic plate because these have high rubber elasticity and have flexibility and impact resilience suitable for formation of the flexographic plate. To enable high-definition printing, the composition for a photosensitive flexographic plate should also have wear resistance, ink swelling resistance, and the like. For this reason, various studies have been conducted to improve aromatic vinyl-conjugated diene-aromatic vinyl block copolymers used to constitute the composition for a photosensitive flexographic plate.

For example, Patent Document 1 discloses a flexographic printing original plate comprising a support, and a photosensitive resin composition layer laminated on the support, wherein the photosensitive resin composition layer contains a thermoplastic elastomer (a), a photopolymerizable unsaturated monomer (b), and a photopolymerization initiator (c); the thermoplastic elastomer (a) has a block copolymer (a-1) represented by any one of General Formulae (I) to (VII) below, the block copolymer (a-1) having a polymer block (A) mainly composed of at least one vinyl aromatic monomer unit and a polymer block (B) mainly composed of at least one conjugated diene monomer unit, and a block copolymer (a-2) different from the block copolymer (a-1), the block copolymer (a-2) having a polymer block (A) mainly composed of at least two vinyl aromatic monomer units and a polymer block (B) mainly composed of at least one conjugated diene monomer unit; the weight average molecular weight of the entire thermoplastic elastomer (a) is 100,000 or more and 300,000 or less; the block copolymers (a-1) and (a-2) each contain 25.0% by mass or more of vinyl aromatic monomer units; and the vinyl bond amount based on conjugated diene monomer units in each of the block copolymers (a-1) and (a-2) is 20.0% by mass or more:

$$(A-B)_n \qquad (I)$$

$$(A-B)_n A \qquad (II)$$

$$(B-A)_n B \qquad (III)$$

$$(A-B)_n X \qquad (IV)$$

$$(B-A)_n X \qquad (V)$$

$$[(A-B)_n A]X \qquad (VI)$$

$$[(B-A)_n B]X \qquad (VII)$$

where A represents the polymer block (A), B represents the polymer block (B), X represents a residue of a coupling agent or a residue of a polymerization initiator, and n represents an integer of 1 to 5.

RELATED ART DOCUMENTS

PATENT DOCUMENTS

Patent Document 1: JP 2021-47322 A

SUMMARY OF THE INVENTION

PROBLEM TO BE SOLVED BY THE INVENTION

However, the flexographic printing original plate disclosed in Patent Document 1 has insufficient flexibility. Moreover, the technique disclosed in Patent Document 1 has difficulties in simultaneously satisfying the processability of the photosensitive composition for pattern formation for forming the photosensitive resin composition layer and the wear resistance and ink swelling resistance of a flexographic printing original plate to be obtained.

The present invention has been made in consideration of such circumstances. An object of the present invention is to provide a photosensitive composition for pattern formation which can provide a molded body having high photosensitivity, sufficient wear resistance, and high flexibility and high ink swelling resistance.

MEANS FOR SOLVING PROBLEMS

The present inventor, who has conducted extensive research to solve the above problems, has found that the above problems can be solved by a photosensitive composition for pattern formation comprising a block copolymer composition containing a block copolymer A1 represented by specific General Formula (1) or a block copolymer A2 represented by specific General Formula (2), and the weight average molecular weight (Mw) of the entire block copolymer composition is within a specific range, and has completed the present invention.

Specifically, the present invention provides a photosensitive composition for pattern formation comprising a block copolymer composition and a photopolymerization initiator, wherein the block copolymer composition contains a block copolymer A1 represented by General Formula (1) below or a block copolymer A2 represented by General Formula (2) below, and the weight average molecular weight (Mw) of the entire block copolymer composition is 300,000 to 800,000:

$$(Ar^1\text{-}D^1)_m X^1 (D^2)_n \qquad (1)$$

where in General Formula (1), $Ar^1$ is an aromatic monovinyl polymer block, $D^1$ and $D^2$ each represent a conjugated diene polymer block, m is an integer of 1 or more, n is an integer of 1 or more, m+n is an integer of 3 or more, and $X^1$ is a residue of a polyfunctional coupling agent;

$$(Ar\text{-}D)_p X \qquad (2)$$

where in General Formula (2), Ar is an aromatic monovinyl polymer block, D is a conjugated diene polymer block, p is an integer of 3 or more, and X is a residue of a polyfunctional coupling agent.

In the photosensitive composition for pattern formation according to the present invention, preferably, the molecular weight distribution (Mw/Mn) of the block copolymer A1 or the block copolymer A2 is 1.40 or less, and the total content of the block copolymer A1 and the block copolymer A2 in the block copolymer composition is 10% by mass or more.

In the photosensitive composition for pattern formation according to the present invention, preferably, the block copolymer composition contains the block copolymer A1.

In the photosensitive composition for pattern formation according to the present invention, preferably, the block copolymer composition contains the block copolymer A1, and further contains a diblock copolymer B represented by General Formula (3) below or a polymer C represented by General Formula (4) below, the molecular weight distribution (Mw/Mn) of the diblock copolymer B or the polymer C is 1.20 or less, the total content of the diblock copolymer B and the polymer C in the block copolymer composition is 60% by mass or less, the content of aromatic monovinyl monomer units in the block copolymer composition is 5 to 40% by mass, and the block copolymer composition has a melt index of 0.5 to 50 g/10 min, the melt index being measured according to ASTM D1238 (G condition, 200°C, load: 5 kg) :

$$Ar^3\text{-}D^3 \qquad (3)$$

$$D^4 \qquad (4)$$

where in General Formulae (3) and (4), $Ar^3$ is an aromatic monovinyl polymer block, and $D^3$ and $D^4$ each represent a conjugated diene polymer block.

In the photosensitive composition for pattern formation according to the present invention, preferably, the block copolymer composition contains the block copolymer A1, and the ratio $((Ar^1\text{-}D^1)/D^2)$ of the mass of a chain as a branch represented by $Ar^1\text{-}D^1$ to that of a chain as a branch represented by $D^2$ in the block copolymer A1 is 1.0/0.15 to 1.0/2.00.

In the photosensitive composition for pattern formation according to the present invention, preferably, the block copolymer composition contains the block copolymer A1, and the ratio $((Mw(D^1))/(Mw(D^2)))$ of the weight average

molecular weight ($Mw(D^1)$) of the conjugated diene polymer block $D^1$ in the chain as a branch represented by $Ar^1$-$D^1$ to the weight average molecular weight ($Mw(D^2)$) of the chain as a branch represented by $D^2$ in the block copolymer A1 is 1.0/0.3 to 1.0/1.1.

In the photosensitive composition for pattern formation according to the present invention, preferably, the polyfunctional coupling agent is a compound having two or more radical polymerizable groups in its molecule.

Preferably, the photosensitive composition for pattern formation according to the present invention further comprises a photopolymerizable ethylenically unsaturated monomer.

In the photosensitive composition for pattern formation according to the present invention, preferably, the polyfunctional coupling agent is divinylbenzene.

The present invention also provides a flexographic plate formed from the photosensitive composition for pattern formation.

EFFECTS OF INVENTION

The present invention provides a photosensitive composition for pattern formation which can provide a molded body having high photosensitivity, sufficient wear resistance, and high flexibility and high ink swelling resistance.

DESCRIPTION OF EMBODIMENTS

<Photosensitive composition for pattern formation>

The photosensitive composition for pattern formation according to the present invention comprises a block copolymer composition and a photopolymerization initiator described later.

1. Block copolymer composition

The block copolymer composition used in the present invention contains a block copolymer A1 described later or a block copolymer A2 described later, and the weight average molecular weight (Mw) of the entire block copolymer composition is 300,000 to 800,000. The block copolymer composition used in the present invention may contain any one of the block copolymer A1 and the block copolymer A2, or may contain both of them.

(1-1) Block copolymer A1

The block copolymer A1 is a block copolymer represented by General Formula (1) below:

$$(Ar^1\text{-}D^1)_m X^1 (D^2)_n \qquad\qquad (1)$$

where in General Formula (1), $Ar^1$ is an aromatic monovinyl polymer block, $D^1$ and $D^2$ each represent a conjugated diene polymer block, m is an integer of 1 or more, n is an integer of 1 or more, m+n is an integer of 3 or more, and $X^1$ is a residue of a polyfunctional coupling agent.

In General Formula (1), $Ar^1$-$D^1$ and $D^2$ each represent a chain as a branch bonded to $X^1$, m is the number of chains as branches represented by $Ar^1$-$D^1$ which are bonded to $X^1$, and n is the number of chains as branches represented by $D^2$ which are bonded to $X^1$. m+n is the total number of chains as branches represented by $Ar^1$-$D^1$ and chains as branches represented by $D^2$, and thus represents the number of branches of the block copolymer A1. $Ar^1$ is an aromatic monovinyl polymer block, and $D^1$ and $D^2$ each represent a conjugated diene polymer block.

In General Formula (1), m is an integer of 1 or more, n is an integer of 1 or more, and m+n is an integer of 3 or more. Specifically, the block copolymer A1 has a branched structure formed of three or more chains as branches, and as the chains as branches, contains both of the chain as a branch represented by $Ar^1$-$D^1$ (a diblock chain containing an aromatic monovinyl polymer block and a conjugated diene polymer block) and the chain as a branch represented by $D^2$ (a conjugated diene polymer block chain).

In General Formula (1), m+n is an integer of 3 or more, preferably 4 to 20, more preferably 5 to 15, still more preferably 6 to 10, although not particularly limited thereto. When m+n falls within the ranges above, the photosensitivity of the photosensitive composition for pattern formation can be further enhanced, and the wear resistance, flexibility, and ink swelling resistance of a molded body to be obtained can be further enhanced, m+n can be controlled by adjusting the structure of the chain as a branch represented by $Ar^1$-$D^1$, that of the chain as a branch represented by $D^2$, and coupling conditions (the type and amount of the polyfunctional coupling agent to be used).

The block copolymer A1 may be composed of only one block copolymer having a substantially single configuration, or may be composed of two or more block copolymers having substantially different configurations.

Alternatively, the block copolymer A1 may be a mixture of block copolymers having different integers for any one of m, n, and m+n. When the average molecular weight of the block copolymer A1 is determined by measurement using high performance liquid chromatography described later and m, n, and m+n are calculated, the averages are calculated for m, n, and m+n in the block copolymers in the mixture. Although these calculated values may not be always integers, in the present invention, integers closest to the calculated values may be defined as m, n, and m+n, respectively.

(1-1-1) Aromatic monovinyl polymer block $Ar^1$

The aromatic monovinyl polymer block $Ar^1$ constituting the block copolymer A1 is a polymer block having an aromatic monovinyl monomer unit as its constitutional unit. Any aromatic monovinyl monomer can be used without limitation to constitute the aromatic monovinyl monomer unit for the aromatic monovinyl polymer block $Ar^1$ as long as it is an aromatic vinyl compound having one radical polymerizable group, and examples thereof include styrene, $\alpha$-methylstyrene, 2-methylstyrene, 3-methylstyrene, 4-methylstyrene, 2-ethylstyrene, 3-ethylstyrene, 4-ethylstyrene, 2,4-diisopropylstyrene, 2,4-dimethylstyrene, 4-t-butylstyrene, 5-t-butyl-2-methylstyrene, 2-chlorostyrene, 3-chlorostyrene, 4-chlorostyrene, 4-bromostyrene, 2-methyl-4,6-dichlorostyrene, 2,4-dibromostyrene, vinylnaphthalene, and the like. Among these aromatic monovinyl monomers, styrene is preferably used. Specifically, the aromatic monovinyl polymer block $Ar^1$ preferably contains styrene units. In this case, the content of styrene units in the aromatic monovinyl polymer block $Ar^1$ is preferably 80 to 100% by mass, more preferably 90 to 100% by mass, but not particularly limited thereto. These aromatic monovinyl monomers can be used alone or in combination in the aromatic monovinyl polymer block $Ar^1$.

The aromatic monovinyl polymer block $Ar^1$ may contain a monomer unit other than the aromatic monovinyl monomer unit. Examples of monomers constituting monomer units other than the aromatic monovinyl monomer unit include conjugated diene monomers such as 1,3-butadiene and isoprene (2-methyl-1,3-butadiene), $\alpha,\beta$-unsaturated nitrile monomers, unsaturated carboxylic acid or acid anhydride monomers, unsaturated carboxylic acid ester monomers, and non-conjugated diene monomers. The content of the monomer unit other than the aromatic monovinyl monomer unit in the aromatic monovinyl polymer block $Ar^1$ is preferably 20% by mass or less, more preferably 10% by mass or less, particularly preferably substantially 0% by mass.

Although the aromatic monovinyl polymer block $Ar^1$ can have any weight average molecular weight ($Mw(Ar^1)$), the weight average molecular weight ($Mw(Ar^1)$ can be within the range of 7,000 to 18,000, and is in the range of preferably 7,500 to 17,000, more preferably 8,000 to 16,000. When the aromatic monovinyl polymer block $Ar^1$ has a weight average molecular weight ($Mw(Ar^1)$) in the ranges above, the photosensitive composition for pattern formation can have enhanced molding properties and photosensitivity, and a molded body to be obtained can have better balanced levels of wear resistance, flexibility, ink swelling resistance, and mechanical strength.

In the present invention, the weight average molecular weights (Mw) and number average molecular weights (Mn) of the polymer blocks, the branched chains, the block copolymers, the block copolymer composition, and the like are determined as values relative to polystyrenes in measurement by high performance liquid chromatography. More specifically, the weight average molecular weight and the number average molecular weight are measured by the method described in Examples.

(1-1-2) Conjugated diene polymer block $D^1$

The conjugated diene polymer block $D^1$ constituting the block copolymer A1 is a polymer block having a conjugated diene monomer unit as its constitutional unit. Any conjugated diene monomer can be used without limitation to constitute the conjugated diene monomer unit for the conjugated diene polymer block $D^1$ as long as it is a conjugated diene compound, and examples thereof include 1,3-butadiene, isoprene (2-methyl-1,3-butadiene), 2,3-dimethyl-1,3-butadiene, 2-chloro-1,3-butadiene, 1,3-pentadiene, 1,3-hexadiene, and the like. Among these conjugated diene monomers, use of 1,3-butadiene and/or isoprene is preferred, and use of isoprene is particularly preferred. Specifically, the conjugated diene polymer block $D^1$ preferably contains isoprene units. In this case, the content of isoprene units in the conjugated diene polymer block $D^1$ is preferably 80 to 100% by mass, more preferably 90 to 100% by mass, but not particularly limited thereto. When isoprene monomer units constitute the conjugated diene polymer block $D^1$, a molded body to be obtained can have better balanced levels of wear resistance, flexibility, ink swelling resistance, and mechanical strength. These conjugated diene monomers can be used alone or in combination in the conjugated diene polymer block $D^1$. Further, the unsaturated bonds of the conjugated diene polymer block $D^1$ may be partially hydrogenated. Specifically, the conjugated diene polymer block $D^1$ may be a non-hydrogenated conjugated diene polymer block, or may be a hydrogenated conjugated diene polymer block.

The conjugated diene polymer block $D^1$ may contain a monomer unit other than the conjugated diene monomer unit. Examples of monomers constituting monomer units other than the conjugated diene monomer unit include aromatic monovinyl monomers such as styrene and $\alpha$-methylstyrene, $\alpha,\beta$-unsaturated nitrile monomers, unsaturated carboxylic acid or acid anhydride monomers, unsaturated carboxylic acid ester monomers, and non-conjugated diene monomers.

The content of the monomer unit other than the conjugated diene monomer unit in the conjugated diene polymer block $D^1$ is preferably 20% by mass or less, more preferably 10% by mass or less, particularly preferably substantially 0% by mass.

The weight average molecular weight ($Mw(D^1)$) of the conjugated diene polymer block $D^1$ is within the range of preferably 20,000 to 140,000, more preferably 25,000 to 120,000, still more preferably 30,000 to 100,000. When the weight average molecular weight ($Mw(D^1)$) of the conjugated diene polymer block $D^1$ falls within the ranges above, the photosensitive composition for pattern formation can have enhanced molding properties and photosensitivity, and a molded body to be obtained can have better balanced levels of wear resistance, flexibility, ink swelling resistance, and mechanical strength.

(1-1-3) Chain as branch represented by $Ar^1$-$D^1$

The chain as a branch represented by $Ar^1$-$D^1$ which constitutes the block copolymer A1 may be formed using any coupling agent, or may be formed without using any coupling agent. Specifically, the chain as a branch represented by $Ar^1$-$D^1$ may contain a residue of a coupling agent in these polymer blocks or between the polymer blocks, or may contain no residue of the coupling agent. To obtain a molded body having better balances levels of wear resistance, flexibility, ink swelling resistance, and mechanical strength, preferably, the chain as a branch represented by $Ar^1$-$D^1$ is the one that is formed without using any coupling agent and contains no residue of a coupling agent in the polymer blocks and between the polymer blocks.

The weight average molecular weight ($Mw(Ar^1$-$D^1)$) of the chain as a branch represented by $Ar^1$-$D^1$ is within the range of preferably 30,000 to 150,000, more preferably 35,000 to 130,000, still more preferably 40,000 to 110,000. When the weight average molecular weight ($Mw(Ar^1$-$D^1)$) of the chain as a branch represented by $Ar^1$-$D^1$ falls within the ranges above, the photosensitive composition for pattern formation can have enhanced molding properties and photosensitivity, and a molded body to be obtained can have better balanced levels of wear resistance, flexibility, ink swelling resistance, and mechanical strength.

The molecular weight distribution ($Mw/Mn$) of the chain as a branch represented by $Ar^1$-$D^1$ is within the range of preferably 1.20 or less, more preferably 1.00 to 1.20, still more preferably 1.00 to 1.18, particularly preferably 1.00 to 1.13, particularly preferably 1.00 to 1.10. When the molecular weight distribution ($Mw/Mn$) of the chain as a branch represented by $Ar^1$-$D^1$ falls within the ranges above, a molded body to be obtained can have better balanced levels of wear resistance, flexibility, ink swelling resistance, and mechanical strength.

(1-1-4) Chain as branch represented by $D^2$

The chain as a branch represented by $D^2$ constituting the block copolymer A1 is a polymer block chain having a conjugated diene monomer unit as its constitutional unit.

Any conjugated diene monomer can be used without limitation to constitute the conjugated diene monomer unit for the conjugated diene polymer block $D^2$ as long as it is a conjugated diene compound, and examples thereof include 1,3-butadiene, isoprene (2-methyl-1,3-butadiene), 2,3-dimethyl-1,3-butadiene, 2-chloro-1,3-butadiene, 1,3-pentadiene, 1,3-hexadiene, and the like. Among these conjugated diene monomers, use of 1,3-butadiene and/or isoprene is preferred, and use of isoprene is particularly preferred. When isoprene monomer units constitute the chain as a branch represented by $D^2$, a molded body to be obtained can have better balanced levels of wear resistance, flexibility, ink swelling resistance, and mechanical strength. These conjugated diene monomers can be used alone or in combination in the chain as a branch represented by $D^2$. Further, the unsaturated bonds of the chain as a branch represented by $D^2$ may be partially hydrogenated.

The chain as a branch represented by $D^2$ may contain a monomer unit other than the conjugated diene monomer unit. Examples of monomers constituting monomer units other than the conjugated diene monomer unit include aromatic monovinyl monomers such as styrene and $\alpha$-methylstyrene, $\alpha,\beta$-unsaturated nitrile monomers, unsaturated carboxylic acid or acid anhydride monomers, unsaturated carboxylic acid ester monomers, and non-conjugated diene monomers. The content of the monomer unit other than the conjugated diene monomer unit in the conjugated diene polymer block $D^2$ is preferably 20% by mass or less, more preferably 10% by mass or less, particularly preferably substantially 0% by mass.

The weight average molecular weight ($Mw(D^2)$) of the chain as a branch represented by $D^2$ is within the range of preferably 20,000 to 140,000, more preferably 25,000 to 120,000, still more preferably 30,000 to 100,000, but not particularly limited thereto. When the weight average molecular weight ($Mw(D^2)$) of the conjugated diene polymer block $D^2$ falls within the ranges above, the photosensitive composition for pattern formation can have enhanced molding properties and photosensitivity, and a molded body to be obtained can have better balanced levels of wear resistance, flexibility, ink swelling resistance, and mechanical strength.

(1-1-5) Residue of polyfunctional coupling agent

The coupling agent forming a residue $X^1$ of a polyfunctional coupling agent in the block copolymer A1 is any coupling agent as long as it can bond to the chain as a branch represented by $Ar^1$-$D^1$ and the chain as a branch represented by $D^2$ to give a block copolymer having three or more chains as branches in total.

Examples of the polyfunctional coupling agent include silane compounds such as halogenated silanes such as tetrachlorosilane and tetrabromosilane, and alkoxysilanes such as tetramethoxysilane and tetraethoxysilane; tin compounds such as tin halides such as tetrachlorotin; epoxy compounds such as polycarboxylic acid esters and epoxidized soybean oil; compounds having two or more radical polymerizable groups in the molecule; and the like.

Examples of compounds having two or more radical polymerizable groups in the molecule include aromatic divinyl compounds such as divinylbenzene (DVB), divinyltoluene, divinylxylene, divinylanthracene, divinylnaphthalene, divinyldurene, and 1,2-bis(4-vinylphenyl)ethane; aromatic trivinyl compounds such as trivinyl benzene; radical polymerizable aromatic compounds having two or more radical polymerizable group and aromatic rings, such as aromatic tetravinyl compounds such as tetravinyl benzene; radical polymerizable aliphatic compounds having two or more radical polymerizable groups and an aliphatic group, such as pentaerythritol tetraacrylate; and the like.

In the present invention, preferred polyfunctional coupling agents are compounds having two or more radical polymerizable groups in the molecule. Among these, preferred are radical polymerizable aromatic compounds, and particularly preferred are aromatic divinyl compounds. Among these, particularly preferred is divinylbenzene. By using these coupling agents, the block copolymer A1 where the number (m+n) of branches falls within the suitable ranges above can be easily obtained, a photosensitive composition for pattern formation having further enhanced photosensitivity can be obtained, and a molded body to be obtained can have further enhanced wear resistance, flexibility, and ink swelling resistance.

(1-1-6) Block copolymer A1

In the block copolymer A1, the ratio (($Ar^1$-$D^1$)/$D^2$) of the mass of the chain as a branch represented by $Ar^1$-$D^1$ to that of the chain as a branch represented by $D^2$ is preferably 1.0/0.15 to 1.0/2.00, more preferably 1.0/0.20 to 1.0/1.75, but not particularly limited thereto. When the ratio (($Ar^1$-$D^1$)/$D^2$) falls within the ranges above, a molded body to be obtained can have better balanced levels of wear resistance, flexibility, ink swelling resistance, and mechanical strength.

In the block copolymer A1, the ratio (($Mw(D^1)$)/($Mw(D^2)$)) of the weight average molecular weight ($Mw(D^1)$) of the conjugated diene polymer block $D^1$ in the chain as a branch represented by $Ar^1$-$D^1$ to the weight average molecular weight ($Mw(D^2)$) of the chain as a branch represented by $D^2$ is preferably 1.0/0.3 to 1.0/1.1, more preferably 1.0/0.45 to 1.0/1.03, but not particularly limited thereto. When the ratio (($Mw(D^1)$)/($Mw(D^2)$)) falls within the ranges above, a molded body to be obtained can have better balanced levels of wear resistance, flexibility, ink swelling resistance, and mechanical strength.

The weight average molecular weight (MwA1) of the block copolymer A1 is within the range of preferably 300,000 to 800,000, more preferably 320,000 to 750,000, still more preferably 340,000 to 700,000, particularly preferably 360,000 to 650,000, most preferably 380,000 to 600,000. When the weight average molecular weight (MwA1) of the block copolymer A1 falls within the ranges above, the photosensitive composition for pattern formation can have enhanced molding properties and photosensitivity, and a molded body to be obtained can have better balanced levels of wear resistance, flexibility, ink swelling resistance, and mechanical strength.

The molecular weight distribution (Mw/Mn) of the block copolymer A1 is preferably 1.40 or less, more preferably 1.00 to 1.30, still more preferably 1.00 to 1.20, particularly preferably 1.00 to 1.18, most preferably 1.00 to 1.16. When the molecular weight distribution (Mw/Mn) of the block copolymer A1 falls within the ranges above, a molded body to be obtained can have better balanced levels of wear resistance, flexibility, ink swelling resistance, and mechanical strength.

The content of the aromatic monovinyl monomer unit of the block copolymer A1 (proportion of the aromatic monovinyl monomer unit in the total monomer units constituting the block copolymer A1) is within the range of preferably 5 to 40% by mass, more preferably 7 to 35% by mass, still more preferably 9 to 30% by mass, particularly preferably 10 to 28% by mass, most preferably 13 to 26% by mass. When the content of the aromatic monovinyl monomer unit of the block copolymer A1 falls within the ranges above, a molded body to be obtained can have better balanced levels of wear resistance, flexibility, ink swelling resistance, and mechanical strength.

The vinyl bond content in the conjugated diene monomer unit of the block copolymer A1 (proportion of the 1,2-vinyl bond and the 3,4-vinyl bond in the total conjugated diene monomer units constituting the block copolymer A1) is within the range of preferably 1 to 20% by mass, more preferably 1 to 15% by mass, particularly preferably 1 to 10% by mass. When the vinyl bond content in the conjugated diene monomer unit of the block copolymer A1 falls within the ranges above, a molded body to be obtained can have better balanced levels of wear resistance, flexibility, ink swelling resistance, and mechanical strength.

(1-2) Block copolymer A2

The block copolymer composition used in the present invention may contain a block copolymer A2 described later instead of the block copolymer A1, or may contain the block copolymer A2 together with the block copolymer A1.
The block copolymer A2 is a block copolymer represented by General Formula (2) below:

$$(Ar-D)_pX \qquad (2)$$

where in General Formula (2), Ar is an aromatic monovinyl polymer block, D is a conjugated diene polymer block, p is an integer of 3 or more, and X is a residue of a polyfunctional coupling agent.
In General Formula (2), Ar-D is a chain as a branch bonded to X; and p is the number of chains as branches represented by Ar-D which are bonded to X, and thus represents the number of branches of the block copolymer A2. Ar is an aromatic monovinyl polymer block, and D is a conjugated diene polymer block.
In General Formula (2), p is an integer of 3 or more. Specifically, the block copolymer A2 has a branched structure formed of three or more chains as branches, and the chains as branches are chains as branches represented by Ar-D (a diblock chain containing an aromatic monovinyl polymer block and a conjugated diene polymer block).
In General Formula (2), p is an integer of 3 or more, preferably 4 to 20, more preferably 5 to 15, still more preferably 6 to 10, but not particularly limited thereto. When p falls within the ranges above, the photosensitive composition for pattern formation can have further enhanced photosensitivity, and a molded body to be obtained can have further enhanced wear resistance, flexibility, and ink swelling resistance. p can be adjusted by controlling the structure of the chain as a branch represented by Ar-D and coupling conditions (such as the type and amount of the polyfunctional coupling agent to be used).
The block copolymer A2 may be composed of only one block copolymer having a substantially single configuration, or may be composed of two or more block copolymers having substantially different configurations.
Alternatively, the block copolymer A2 may be a mixture of block copolymers having different integers for p. When the average molecular weight of the block copolymer A2 is determined by measurement using high performance liquid chromatography described later and p is calculated, the average is calculated for p in the block copolymers in the mixture. Although these calculated values may not be always integers, in the present invention, an integer closest to the calculated value may be defined as p.

(1-2-1) Aromatic monovinyl polymer block Ar

The aromatic monovinyl polymer block Ar constituting the block copolymer A2 is a polymer block having an aromatic monovinyl monomer unit as its constitutional unit. Examples of aromatic monovinyl monomers used to constitute the aromatic monovinyl monomer unit for the aromatic monovinyl polymer block Ar include the same aromatic monovinyl monomers as those used to constitute the aromatic monovinyl monomer unit for the aromatic monovinyl polymer block Ar[1] in the block copolymer A1. Among these, preferred is styrene. Specifically, the aromatic monovinyl polymer block Ar preferably contains styrene units. In this case, the content of styrene units in the aromatic monovinyl polymer block Ar is preferably 80 to 100% by mass, more preferably 90 to 100% by mass, but not particularly limited thereto. These aromatic monovinyl monomers can be used alone or in combination in the aromatic monovinyl polymer block Ar.
The aromatic monovinyl polymer block Ar may contain a monomer unit other than the aromatic monovinyl monomer unit. Examples of monomers constituting monomer units other than the aromatic monovinyl monomer unit include conjugated diene monomers such as 1,3-butadiene and isoprene (2-methyl-1,3-butadiene), $\alpha,\beta$-unsaturated nitrile monomers, unsaturated carboxylic acid or acid anhydride monomers, unsaturated carboxylic acid ester monomers, and non-conjugated diene monomers. The content of the monomer unit other than the aromatic monovinyl monomer unit in the aromatic monovinyl polymer block Ar is preferably 20% by mass or less, more preferably, 10% by mass or less, particularly preferably substantially 0% by mass.
Although the aromatic monovinyl polymer block Ar can have any weight average molecular weight (Mw(Ar)), the weight average molecular weight (Mw(Ar)) can be within the range of 7,000 to 18,000, and is within the range of preferably 7,500 to 17,000, more preferably 8,000 to 16,000. When the weight average molecular weight (Mw(Ar)) of the aromatic monovinyl polymer block Ar falls within the ranges above, the photosensitive composition for pattern formation can have enhanced molding properties and photosensitivity, and a molded body to be obtained can have better balanced levels of wear resistance, flexibility, ink swelling resistance, and mechanical strength.

(1-2-2) Conjugated diene polymer block D

The conjugated diene polymer block D constituting the block copolymer A2 is a polymer block having a conjugated diene monomer unit as its constitutional unit. Examples of conjugated diene monomers used to constitute the conjugated diene monomer unit for the conjugated diene polymer block D include the same conjugated diene monomers used to constitute the conjugated diene monomer unit for the conjugated diene polymer block $D^1$ in the block copolymer A1. Among these, preferred is use of 1,3-butadiene and/or isoprene, and particularly preferred is use of isoprene. Specifically, the conjugated diene polymer block D preferably contains isoprene units. In this case, the content of isoprene units in the conjugated diene polymer block D is preferably 80 to 100% by mass, more preferably 90 to 100% by mass, but not particularly limited thereto. When isoprene monomer units constitute the conjugated diene polymer block D, a molded body to be obtained can have better balanced levels of wear resistance, flexibility, ink swelling resistance, and mechanical strength. These conjugated diene monomers can be used alone or in combination in the conjugated diene polymer block D. Further, the unsaturated bonds of the conjugated diene polymer block D may be partially hydrogenated. Specifically, the conjugated diene polymer block D may be a non-hydrogenated conjugated diene polymer block, or may be a hydrogenated conjugated diene polymer block.

The conjugated diene polymer block D may contain a monomer unit other than the conjugated diene monomer unit. Examples of monomers constituting monomer units other than the conjugated diene monomer unit include aromatic monovinyl monomers such as styrene and $\alpha$-methylstyrene, $\alpha,\beta$-unsaturated nitrile monomers, unsaturated carboxylic acid or acid anhydride monomers, unsaturated carboxylic acid ester monomers, and non-conjugated diene monomers. The content of the monomer unit other than the conjugated diene monomer unit in the conjugated diene polymer block D is preferably 20% by mass or less, more preferably 10% by mass or less, particularly preferably substantially 0% by mass.

The weight average molecular weight (Mw(D)) of the conjugated diene polymer block D is within the range of preferably 20,000 to 140,000, more preferably 25,000 to 120,000, still more preferably 30,000 to 100,000. When the weight average molecular weight (Mw(D)) of the conjugated diene polymer block D falls within the ranges above, the photosensitive composition for pattern formation can have enhanced molding properties and photosensitivity, and a molded body to be obtained can have better balanced levels of wear resistance, flexibility, ink swelling resistance, and mechanical strength.

(1-2-3) Chain as branch represented by Ar-D

The chain as a branch represented by Ar-D which constitutes the block copolymer A2 may be formed using any coupling agent, or may be formed without using any coupling agent. Specifically, the chain as a branch represented by Ar-D may contain a residue of a coupling agent in these polymer blocks or between the polymer blocks, or may contain no residue of the coupling agent. To obtain a molded body having better balanced levels of wear resistance, flexibility, ink swelling resistance, and mechanical strength, preferably, the chain as a branch represented by Ar-D is the one that is formed without using any coupling agent and contains no residue of a coupling agent in the polymer blocks and between the polymer blocks.

The weight average molecular weight (Mw(Ar-D)) of the chain as a branch represented by Ar-D is within the range of preferably 30,000 to 150000, more preferably 35,000 to 130,000, still more preferably 40,000 to 110,000. When the weight average molecular weight (Mw(Ar-D)) of the chain as a branch represented by Ar-D falls within the ranges above, the photosensitive composition for pattern formation can have enhanced molding properties and photosensitivity, and a molded body to be obtained can have better balanced levels of wear resistance, flexibility, ink swelling resistance, and mechanical strength.

The molecular weight distribution (Mw/Mn) of the chain as a branch represented by Ar-D is within the range of preferably 1.20 or less, more preferably 1.00 to 1.20, still more preferably 1.00 to 1.18, particularly preferably 1.00 to 1.13, particularly preferably 1.00 to 1.10. When the molecular weight distribution (Mw/Mn) of the chain as a branch represented by Ar-D falls within the ranges above, a molded body to be obtained can have better balanced levels of wear resistance, flexibility, ink swelling resistance, and mechanical strength.

(1-2-4) Residue of polyfunctional coupling agent

The coupling agent forming a residue X of a polyfunctional coupling agent in the block copolymer A2 is any block copolymer as long as it can bond to the chain as a branch represented by Ar-D to give a block copolymer having three or more chains as branches in total.

Example of the polyfunctional coupling agent forming a residue X of the polyfunctional coupling agent include the same as those listed as the polyfunctional coupling agents each forming the residue $X^1$ of the polyfunctional coupling agent in the block copolymer A1. Preferably, the polyfunctional coupling agents are compounds having two or more radical polymerizable groups in the molecule. Among these, preferred are radical polymerizable aromatic compounds, and particularly preferred are aromatic divinyl compounds. Among these, particularly preferred is divinylbenzene. By using these coupling agents, the block copolymer A2 where the number (p) of chains as branches falls within the suitable ranges above can be easily obtained, a photosensitive composition for pattern formation having further enhanced photosensitivity can be obtained, and a molded body to be obtained can have further enhanced wear resistance, flexibility, and ink swelling resistance.

(1-2-5) Block copolymer A2

The weight average molecular weight (MwA2) of the block copolymer A2 is within the range of preferably 300,000 to 800,000, more preferably 320,000 to 750,000, still more preferably 340,000 to 700,000, particularly preferably 360,000 to 650,000, most preferably 380,000 to 600,000. When the weight average molecular weight (MwA2) of the block copolymer A2 falls within the ranges, the photosensitive composition for pattern formation can have enhanced molding properties and photosensitivity, and a molded body to be obtained can have better balanced levels of wear resistance, flexibility, ink swelling resistance, and mechanical strength.

The molecular weight distribution (Mw/Mn) of the block copolymer A2 is preferably 1.40 or less, more preferably 1.00 to 1.30, still more preferably 1.00 to 1.20, particularly preferably 1.00 to 1.18, most preferably 1.00 to 1.16. When the molecular weight distribution (Mw/Mn) of the block copolymer A2 falls within the ranges above, a molded body to be obtained can have better balanced levels of wear resistance, flexibility, ink swelling resistance, and mechanical strength.

The content of the aromatic monovinyl monomer unit of the block copolymer A2 (proportion of the aromatic monovinyl monomer unit in the total monomer units constituting the block copolymer A2) is within the range of preferably 5 to 40% by mass, more preferably 7 to 35% by mass, still more preferably 9 to 30% by mass, particularly preferably 10 to 28% by mass, most preferably 13 to 26% by mass. When the content of the aromatic monovinyl monomer unit of the block copolymer A2 falls within the ranges above, a molded body to be obtained can have better balanced levels of wear resistance, flexibility, ink swelling resistance, and mechanical strength.

The vinyl bond content in the conjugated diene monomer unit of the block copolymer A2 (proportion of the 1,2-vinyl bond and the 3,4-vinyl bond in the total conjugated diene monomer units constituting the block copolymer A2) is within the range of preferably 1 to 20% by mass, more preferably 1 to 15% by mass, particularly preferably 1 to 10% by mass. When the vinyl bond content in the conjugated diene monomer unit of the block copolymer A2 falls within the ranges above, a molded body to be obtained can have better balanced levels of wear resistance, flexibility, ink swelling resistance, and mechanical strength.

(1-3) Diblock copolymer B

The block copolymer composition used in the present invention may contain a diblock copolymer B in addition to the block copolymer A1 or the block copolymer A2.

The diblock copolymer B is a diblock copolymer represented by General Formula (3) below:

$$Ar^3\text{-}D^3 \qquad (3)$$

where in General Formula (3), $Ar^3$ is an aromatic monovinyl polymer block, and $D^3$ is a conjugated diene polymer block.

When the block copolymer composition contains the block copolymer A1, the diblock copolymer B usually has the same configuration as that of the chain as a branch represented by $Ar^1\text{-}D^1$ constituting the block copolymer A1, but can has a different configuration. In this case, the aromatic monovinyl polymer block $Ar^3$ and the conjugated diene polymer block $D^3$ which constitute the diblock copolymer B are as described in the aromatic monovinyl polymer block $Ar^1$ and the conjugated diene polymer block $D^1$ in the block copolymer A1, and suitable examples are as described above. According to a method of producing the block copolymer A1 described later, usually, the configuration of the diblock copolymer B can be the same configuration as that of the chain as a branch represented by $Ar^1\text{-}D^1$ constituting the block copolymer A1.

When the block copolymer composition contains the block copolymer A2, the diblock copolymer B usually has the same configuration as that of the chain as a branch represented by Ar-D constituting the block copolymer A2, but can have a different configuration. In this case, the aromatic monovinyl polymer block $Ar^3$ and the conjugated diene polymer block $D^3$ which constitute the diblock copolymer B are as described in the aromatic monovinyl polymer block Ar and the conjugated diene polymer block D in the block copolymer A2, and suitable examples are as described above. According to the method of producing the block copolymer A2 described later, usually, the configuration of the diblock copolymer B can be the same configuration of the chain as a branch represented by Ar-D constituting the block copolymer A2.

The diblock copolymer B may be formed using any coupling agent, or may be formed without using any coupling agent. Preferably, the diblock copolymer B contains no residue of a coupling agent in the polymer blocks and between the polymer blocks.

The weight average molecular weight (MwB) of the diblock copolymer B is within the range of preferably 30,000 to 150,000, more preferably 35,000 to 130,000, still more preferably 40,000 to 110,000. When the weight average molecular weight (MwB) of the diblock copolymer B falls within the ranges above, the photosensitive composition for pattern formation can have enhanced molding properties and photosensitivity, and a molded body to be obtained can have better balanced levels of wear resistance, flexibility, ink swelling resistance, and mechanical strength.

The molecular weight distribution (Mw/Mn) of the diblock copolymer B is within the range of preferably 1.20 or less, more preferably 1.00 to 1.20, still more preferably 1.00 to 1.18, particularly preferably 1.00 to 1.13, particularly preferably 1.00 to 1.10. When the molecular weight distribution (Mw/Mn) of the diblock copolymer B falls within the ranges above, a molded body to be obtained can have better balanced levels of wear resistance, flexibility, ink swelling resistance, and mechanical strength.

The content of the aromatic monovinyl monomer unit of the diblock copolymer B (proportion of the aromatic monovinyl monomer unit in the total monomer units constituting the diblock copolymer B) is within the range of preferably 5 to 40% by mass, more preferably 7 to 35% by mass, still more preferably 9 to 30% by mass, particularly preferably 10 to 28% by mass, most preferably 13 to 26% by mass.

The vinyl bond content in the conjugated diene monomer unit of the diblock copolymer B (proportion of the 1,2-vinyl bond and the 3,4-vinyl bond in the total conjugated diene monomer units constituting the diblock copolymer B) is within the range of preferably 1 to 20% by mass, more preferably 1 to 15% by mass, particularly preferably 1 to 10% by mass.

The diblock copolymer B constituting the block copolymer composition used in the present invention may be composed of only one diblock copolymer B having a substantially single configuration, or may be composed of two or more diblock copolymers B having substantially different configurations.

(1-4) Polymer C

The block copolymer composition used in the present invention may contain a polymer C in addition to the block copolymer A1 or the block copolymer A2 and the diblock copolymer B which is optionally used.

The polymer C is a conjugated diene polymer having a conjugated diene monomer unit as its constitutional unit, the conjugated diene polymer being represented by General Formula (4) below:

$$D^4 \qquad (4)$$

where in General Formula (4), $D^4$ is a conjugated diene polymer block.

The polymer C is a conjugated diene polymer having a conjugated diene monomer unit as its constitutional unit. Examples of conjugated diene monomers used to constitute the conjugated diene monomer unit for the polymer C include the same conjugated diene monomers used to constitute the conjugated diene polymer block $D^2$ constituting the block copolymer A1. Among these, use of 1,3-butadiene and/or isoprene is preferred, and use of isoprene is particularly preferred. Specifically, the polymer C preferably contains isoprene units. In this case, the content of the isoprene units in the polymer C is preferably 80 to 100% by mass, more preferably 90 to 100% by mass, but not particularly limited thereto. When the isoprene monomer units constitute the polymer C, a molded body to be obtained can have better balanced levels of wear resistance, flexibility, ink swelling resistance, and mechanical strength. These conjugated diene monomers can be used alone or in combination in the polymer C. Further, the unsaturated bonds of the polymer C may be partially hydrogenated. Specifically, the polymer C may be a non-hydrogenated conjugated diene polymer, or may be a hydrogenated conjugated diene polymer.

The polymer C contains a monomer unit other than the conjugated diene monomer unit. Examples of monomers constituting monomer units other than the conjugated diene monomer unit include aromatic monovinyl monomers such as styrene and α-methylstyrene, α,β-unsaturated nitrile monomers, unsaturated carboxylic acid or acid anhydride monomers, unsaturated carboxylic acid ester monomers, and non-conjugated diene monomers. The content of the monomer unit other than the conjugated diene monomer unit in the polymer C is preferably 20% by mass or less, more preferably 10% by mass or less, particularly preferably substantially 0% by mass.

When the block copolymer composition contains the block copolymer A1, the polymer C usually has the same configuration as that of the conjugated diene polymer block $D^2$ constituting the block copolymer A1, but can have a different configuration. When the block copolymer composition contains the block copolymer A1, the polymer C can be as described in the conjugated diene polymer block $D^2$ in the block copolymer A1, and suitable examples are as described above. According to the method of producing the block copolymer A1 described later, the configuration of the polymer C can be usually the same configuration of the conjugated diene polymer block $D^2$ constituting the block copolymer A1.

The weight average molecular weight (MwC) of the polymer C is within the range of preferably 20,000 to 140,000, more preferably 25,000 to 120,000, still more preferably 30,000 to 100,000. When the weight average molecular weight (MwC) of the polymer C falls within the ranges above, the photosensitive composition for pattern formation can have enhanced molding properties and photosensitivity, and a molded body to be obtained can have better balanced levels of wear resistance, flexibility, ink swelling resistance, and mechanical strength.

The molecular weight distribution (Mw/Mn) of the polymer C is within the range of preferably 1.20 or less, more preferably 1.00 to 1.20, still more preferably 1.00 to 1.18, particularly preferably 1.00 to 1.13, particularly preferably 1.00 to 1.10. When the molecular weight distribution (Mw/Mn) of the polymer C falls within the ranges above, a molded body to be obtained can have better balanced levels of wear resistance, flexibility, ink swelling resistance, and mechanical strength.

The vinyl bond content in the conjugated diene monomer unit in the polymer C (proportion of the 1,2-vinyl bond and the 3,4-vinyl bond in the total conjugated diene monomer units constituting the polymer C) is within the range of preferably 1 to 20% by mass, more preferably 1 to 15% by mass, particularly preferably 1 to 10% by mass.

The polymer C may be composed of one polymer C having a substantially a single configuration, or may be composed of two or more polymers C having substantially different configurations.

(1-5) Block copolymer composition

The block copolymer composition used in the present invention contains the block copolymer A1 or the block copolymer A2, and the weight average molecular weight (Mw) of the entire block copolymer composition is 300,000 to 800,000. The block copolymer composition may optionally contain the diblock copolymer B, or may optionally contain the polymer C.

The weight average molecular weight (Mw) of the entire block copolymer composition is within the range of 300,000 to 800,000. When the weight average molecular weight (Mw) of the entire block copolymer composition is extremely small, a molded body to be obtained may have poor flexibility. When the weight average molecular weight (Mw) of the entire block copolymer composition is extremely small, it may be difficult to simultaneously satisfy the processability of the photosensitive composition for pattern formation and the wear resistance and ink swelling resistance of a molded body to be obtained. In contrast, when the weight average molecular weight (Mw) of the entire block copolymer composition is extremely large, processability may be reduced, and a molded body may not be formed in some cases. Because the photosensitive composition for pattern formation can have enhanced molding properties and photosensitivity and a molded body to be obtained can have better balanced levels of wear resistance, flexibility, ink swelling resistance, and mechanical strength, the weight average molecular weight (Mw) of the entire block copolymer composition is within the range of preferably 320,000 to 750,000, more preferably 340,000 to 700,000, still more preferably 360,000 to 650,000, particularly preferably 380,000 to 600,000.

The molecular weight distribution, which is represented as the ratio (Mw/Mn) of the weight average molecular weight (Mw) of the entire block copolymer composition to the number average molecular weight (Mn) thereof, is within the range of preferably 1.01 to 2.50, more preferably 1.02 to 2.20, still more preferably 1.02 to 2.0.

When the block copolymer composition contains the block copolymer A1, the content of the block copolymer A1 in the block copolymer composition is within the range of preferably 10% by mass or more, more preferably 30 to 99% by mass, still more preferably 40 to 99% by mass, further still more preferably 50 to 99% by mass, further still more preferably 60 to 99% by mass, particularly preferably 70 to 99% by mass, further particularly preferably 75 to 98% by mass, most preferably 80 to 98% by mass in 100% by mass of the total mass of the block copolymer composition. When the content of the block copolymer A1 in the block copolymer composition falls within the ranges above, the photosensitive composition for pattern formation can have enhanced molding properties and photosensitivity, and a molded body to be obtained can have better balanced levels of wear resistance, flexibility, ink swelling resistance, and mechanical strength.

When the block copolymer composition contains the block copolymer A2, the content of the block copolymer A2 in the block copolymer composition is within the range of preferably 10% by mass or more, more preferably 30 to 99% by mass, still more preferably 40 to 99% by mass, further still more preferably 50 to 99% by mass, further still more preferably 60 to 99% by mass, particularly preferably 70 to 99% by mass, further particularly preferably 75 to 98% by mass, most preferably 80 to 98% by mass in 100% by mass of the total mass of the block copolymer composition. When the content of the block copolymer A2 in the block copolymer composition falls within the ranges above, the photosensitive composition for pattern formation can have enhanced molding properties and photosensitivity, and a molded body to be obtained can have better balanced levels of wear resistance, flexibility, ink swelling resistance, and mechanical strength.

The total content of the block copolymer A1 and the block copolymer A2 in the block copolymer composition is within the range of preferably 10% by mass or more, more preferably 30 to 99% by mass, still more preferably 40 to 99% by mass, further still more preferably 50 to 99% by mass, further still more preferably 60 to 99% by mass, particularly preferably 70 to 99% by mass, further particularly preferably 75 to 98% by mass, most preferably 80 to 98% by mass in 100% by mass of the total mass of the block copolymer composition. When the total content of the block copolymer A1 and the block copolymer A2 in the block copolymer composition falls within the ranges above, the photosensitive composition for pattern formation can have enhanced molding properties and photosensitivity, and a molded body to be obtained can have better balanced levels of wear resistance, flexibility, ink swelling resistance, and mechanical strength.

The content of the diblock copolymer B in the block copolymer composition is within the range of preferably 60% by mass or less, more preferably 0 to 40% by mass, still more preferably 0 to 20% by mass, further still more preferably 0 to 10% by mass, particularly preferably 0.5 to 10% by mass, most preferably 1 to 10% by mass in 100% by mass of the total mass of the block copolymer composition. When the content of the diblock copolymer B in the block copolymer composition falls within the ranges above, the photosensitive composition for pattern formation can have enhanced molding properties and photosensitivity, and a molded body to be obtained can have better balanced levels of wear resistance, flexibility, ink swelling resistance, and mechanical strength.

The content of the polymer C in the block copolymer composition is within the range of preferably 60% by mass or less, more preferably 0 to 40% by mass, still more preferably 0 to 20% by mass, further still more preferably 0 to 10% by mass, particularly preferably 0.5 to 10% by mass, most preferably 1 to 10% by mass in 100% by mass of the total mass of the block copolymer composition. When the content of the polymer C in the block copolymer composition falls within the ranges above, the photosensitive composition for pattern formation can have enhanced molding properties and photosensitivity, and a molded body to be obtained can have better balanced levels of wear resistance, flexibility, ink swelling resistance, and mechanical strength.

The total content of the diblock copolymer B and the polymer C in the block copolymer composition is within the range of preferably 60% by mass or less, more preferably 0 to 40% by mass, still more preferably 0 to 20% by mass, further still more preferably 0 to 10% by mass, particularly preferably 0.5 to 10% by mass, most preferably 1 to 10% by mass in 100% by mass of the total mass of the block copolymer composition. When the total content of the diblock copolymer B and the polymer C in the block copolymer composition falls within the ranges above, the photosensitive composition for pattern formation can have enhanced molding properties and photosensitivity, and a molded body to be obtained can have better balanced levels of wear resistance, flexibility, ink swelling resistance, and mechanical strength.

When the block copolymer composition contains the block copolymer A1, the contents of block copolymer A1/diblock copolymer B/polymer C in the block copolymer composition are preferably 10 to 100/0 to 60/0 to 30 (% by mass), more preferably 30 to 100/0 to 50/0 to 20 (% by mass), still more preferably 30 to 99/0.5 to 50/0.5 to 20 (% by mass), further still more preferably 50 to 99/0.5 to 40/0.5 to 10 (% by mass), further still more preferably 60 to 98/1 to 30/1 to 10 (% by mass), particularly preferably 70 to 98/1 to 20/1 to 10 (% by mass), further particularly preferably 75 to 98/1 to 15/1 to 10 (% by mass), most preferably 80 to 98/1 to 10/1 to 10 (% by mass) in 100% by mass of the total mass of the block copolymer composition.

When the block copolymer composition contains the block copolymer A2, the contents of block copolymer A2/diblock copolymer B/polymer C in the block copolymer composition are preferably 10 to 100/0 to 60/0 to 30 (% by mass), more preferably 30 to 100/0 to 50/0 to 20 (% by mass), still more preferably 30 to 99/0.5 to 50/0.5 to 20 (% by mass), further still more preferably 50 to 99/0.5 to 40/0.5 to 10 (% by mass), further still more preferably 60 to 98/1 to 30/1 to 10 (% by mass), particularly preferably 70 to 98/1 to 20/1 to 10 (% by mass), further particularly preferably 75 to 98/1 to 15/1 to 10 (% by mass), most preferably 80 to 98/1 to 10/1 to 10 (% by mass) in 100% by mass of the total mass of the block copolymer composition.

The contents of (total of the block copolymer A1 and the block copolymer A2)/diblock copolymer B/polymer C in the block copolymer composition are preferably 10 to 100/0 to 60/0 to 30 (% by mass), more preferably 30 to 100/0 to 50/0 to 20 (% by mass), still more preferably 30 to 99/0.5 to 50/0.5 to 20 (% by mass), further still more preferably 50 to 99/0.5 to 40/0.5 to 10 (% by mass), further still more preferably 60 to 98/1 to 30/1 to 10 (% by mass), particularly preferably 70 to 98/1 to 20/1 to 10 (% by mass), further particularly preferably 75 to 98/1 to 15/1 to 10 (% by mass), most preferably 80 to 98/1 to 10/1 to 10 (% by mass) in 100% by mass of the total mass of the block copolymer composition.

Usually, the block copolymer composition used in the present invention is composed of only at least one of the block copolymer A1 and the block copolymer A2, the diblock copolymer B optionally used, and the polymer C optionally used. The photosensitive composition for pattern formation according to the present invention may further comprise a different polymer other than the block copolymer A1, the block copolymer A2, the diblock copolymer B, and the polymer C in the range not inhibiting the effects of the present invention.

The content of aromatic monovinyl monomer units in the block copolymer composition, that is, the proportion of the aromatic monovinyl monomer unit relative to the total amount of the block copolymer composition, i.e., the proportion of the aromatic monovinyl monomer unit relative to the total block copolymer components in the block copolymer composition (hereinafter, referred to as "total content of the aromatic monovinyl monomer unit" in some cases) is within the range of preferably 5 to 40% by mass, more preferably 7 to 35% by mass, still more preferably 9 to 30% by mass, particularly preferably 10 to 28% by mass, most preferably 13 to 26% by mass. When the total content of the aromatic monovinyl monomer unit falls within the ranges above, a molded body to be obtained can have better balanced levels of wear resistance, flexibility, ink swelling resistance, and mechanical strength.

The total content of the aromatic monovinyl monomer unit can be easily controlled by adjusting the blending amounts of the polymers in consideration of the contents of the aromatic monovinyl monomer units in the polymers constituting the block copolymer composition. When all the polymer components constituting the block copolymer composition are constituted only with aromatic monovinyl monomer units and conjugated diene monomer units, according to the method described in Rubber Chem. Technol., 45, 1295 (1972), the polymer components are subjected to ozonolysis, and then are reduced with lithium aluminum hydride, thereby decomposing portions of the conjugated diene monomer units and taking out only portions of the aromatic monovinyl monomer units, so that the total content of the aromatic monovinyl monomer units can be easily measured.

The vinyl bond content in the conjugated diene monomer unit in the block copolymer composition (proportion of the 1,2-vinyl bond and the 3,4-vinyl bond in the total conjugated diene monomer units constituting the block copolymer composition) is within the range of preferably 1 to 20% by mass, more preferably 1 to 15% by mass, particularly preferably 1 to 10% by mass. When the vinyl bond content in the conjugated diene monomer unit in the block copolymer composition falls within the ranges above, a molded body to be obtained can have better balanced levels of wear resistance, flexibility, ink swelling resistance, and mechanical strength.

The melt index of the block copolymer composition as the value measured according to ASTM D1238 (G condition, 200°C, load: 5 kg) is within the range of preferably 0.5 to 50 g/10 min, more preferably 1 to 35 g/10 min, still more preferably 2 to 25 g/10 min. When the melt index of the block copolymer composition falls within the ranges above, the photosensitive composition for pattern formation can have enhanced molding properties and photosensitivity, and a molded body to be obtained can have better balanced levels of wear resistance, flexibility, ink swelling resistance, and mechanical strength.

The type A hardness of the block copolymer composition is preferably 25 to 65, more preferably 26 to 64, still more preferably 27 to 63. When the type A hardness falls within the ranges above, a molded body to be obtained can have better balanced levels of wear resistance, flexibility, ink swelling resistance, and mechanical strength. The type A hardness is a value measured according to JIS K6253 using a durometer hardness tester (type A).

The content of the block copolymer composition in the photosensitive composition for pattern formation is preferably 20 to 99% by weight, more preferably 30 to 95% by weight, still more preferably 40 to 93% by weight, particularly preferably 50 to 92% by weight, most preferably 60 to 91% by weight.

(1-6) Method of producing block copolymer composition

The block copolymer composition used in the present invention can be produced by any method, and examples thereof include a method of producing the block copolymer A1 or the block copolymer A2 as one component of the block copolymer composition when the block copolymer composition is produced by a method of producing a block copolymer composition.

Although the block copolymer composition used in the present invention can be produced in batch by the production method described later, the block copolymer A1 or the block copolymer A2 may be provided, and may be optionally mixed with the diblock copolymer B, the polymer C, and the block copolymer D which are separately prepared.

(1-6-1) Method of producing block copolymer composition containing block copolymer A1

Suitable examples of the method of producing the block copolymer composition containing the block copolymer A1 include a production method comprising:

a polymerization step of polymerizing an aromatic monovinyl monomer in a polymerization solvent using an organolithium initiator to obtain aromatic monovinyl polymer block chains;
a polymerization step of polymerizing a conjugated diene monomer in a polymerization solvent using an organolithium initiator in the presence of the aromatic monovinyl polymer block chains to obtain diblock chains and conjugated diene polymer block chains; and
a coupling step of reacting a polyfunctional coupling agent with the diblock chains and the conjugated diene polymer block chains.

(Polymerization step)

The organolithium initiator used in the polymerization step can be any known organolithium initiator that can initiate polymerization of the aromatic monovinyl monomer and the conjugated diene monomer, and specific examples thereof include organic monolithium initiators such as methyllithium, n-propyllithium, n-butyllithium, and sec-butyllithium. Among these, preferred is n-butyllithium. The amount of the organolithium initiator to be used can be determined by calculation according to the molecular weight of a desired polymer by a method known to persons skilled in the art. In the present invention, since use of the organolithium initiator causes the polymerization reaction to proceed with living properties, a polymer having an active end is present in the polymerization reaction system. For this reason, in the present invention, the polymer chains obtained in the polymerization step can have active ends.

The polymerization solvent can be any polymerization solvent inert to organolithium initiator, and is not particularly limited. For example, an open-chain hydrocarbon solvent, a cyclic hydrocarbon solvent, or a mixed solvent thereof is used. Examples of the open-chain hydrocarbon solvent include $C_4$ to $C_6$ open-chain alkanes and alkenes, such as n-butane, isobutane, n-hexane, or a mixture thereof; 1-butene, isobutylene, trans-2-butene, cis-2-butene, or a mixture thereof; 1-pentene, trans-2-pentene, cis-2-pentene, or a mixture thereof; n-pentane, isopentane, neo-pentane, or a mixture thereof; and 1-pentene, trans-2-pentene, cis-2-pentene, or a mixture thereof. Examples of the cyclic hydrocarbon solvent include aromatic hydrocarbons such as benzene, toluene, and xylene; and alicyclic hydrocarbons such as cyclohexane; and the like. To control the polymerization temperature and control the molecular weight distribution, an open-chain hydrocarbon solvent and a cyclic hydrocarbon solvent are used in the form of a mixture, in which the mass ratio of "the open-chain hydrocarbon solvent to the cyclic hydrocarbon solvent" is more preferably 5:95 to 50:50, still more preferably 10:90 to 40:60.

The polymerization reaction can also be performed in the presence of a polar compound. Use of a polar compound allows adjustment of the polymerization initiation rate and the molecular weight distribution. Examples of the polar compound include aromatic or aliphatic ethers and tertiary amines having a relative permittivity (25°C) of 2.5 to 5.0, and the like. Specific examples of the polar compound include aromatic ethers such as diphenyl ether and anisole; aliphatic ethers such as diethyl ether and dibutyl ether; tertiary monoamines such as trimethylamine, triethylamine, and tripropylamine; tertiary polyamines such as tetramethylethylenediamine and tetraethylethylenediamine; and the like. These polar compounds can be used alone or in combination. The polar compound is used in an amount of preferably 0.001 to 50 mol, more preferably 0.005 to 10 mol relative to 1 mol of the organolithium initiator.

A method of polymerizing the aromatic monovinyl monomer is not particularly limited, and any of generally used methods may be used: for example, a batch polymerization method of feeding the total amount of the aromatic monovinyl monomer and the total amount of the initiator to a polymerization system in batch, and reacting these; a continuous polymerization method of reacting these while continuously feeding these to a polymerization system; and a method of polymerizing part of the monomer using part of the initiator until a predetermined conversion ratio is reached, and then continuing the polymerization by adding the remaining monomer and the remaining initiator. The polymerization is performed at a temperature in the range of usually 0°C to 90°C, preferably 20°C to 80°C. If it is difficult to control the reaction temperature, preferably, the temperature is controlled by reflux cooling using a reaction vessel provided with a reflux type condenser.

By polymerizing the aromatic monovinyl monomer in the solvent using the organolithium initiator under such conditions described above, a solution containing aromatic monovinyl polymer block chains can be obtained. The aromatic monovinyl polymer block chains obtained through the polymerization usually have active ends. Since the aromatic monovinyl polymer block chains obtained will form the aromatic monovinyl polymer block ($Ar^1$) or the aromatic monovinyl polymer block ($Ar^3$), the amount of the monomer used in this polymerization step can be determined according to the weight average molecular weight of the aromatic monovinyl polymer block ($Ar^1$) and that of the aromatic monovinyl polymer block ($Ar^3$).

In the next step, an organolithium initiator and a conjugated diene monomer are added to the resulting solution containing the aromatic monovinyl polymer block chains, followed by polymerization. Thereby, a solution containing diblock chains and conjugated diene polymer block chains can be obtained. Note that the organolithium initiator and the conjugated diene monomer can be added, at any timing, to the solution containing aromatic monovinyl polymer block chains. For example, the conjugated diene monomer may be added after addition of the organolithium initiator; or part of the conjugated diene monomer may be added, then, the organolithium initiator may be added, and thereafter, a remaining part of the conjugated diene monomer may be added. The diblock chains and the conjugated diene polymer block chains obtained through polymerization usually have active ends. In the diblock chains obtained, polymer chains which will form the conjugated diene polymer block ($D^1$) or the conjugated diene polymer block ($D^3$) are further bonded to the polymer chains which will form the aromatic monovinyl polymer block ($Ar^1$) and the aromatic monovinyl polymer block ($Ar^3$). Furthermore, the conjugated diene polymer block chains obtained will form the conjugated diene polymer block ($D^2$) and the polymer C. For this reason, the amount of the monomer used in this polymerization step can be determined according to the weight average molecular weight of the conjugated diene polymer block ($D^1$), that of the conjugated diene polymer block ($D^2$), that of the conjugated diene polymer block ($D^3$), and that of the polymer C. It is sufficient that the polymerization reaction temperature, the polymerization time, and the polymerization pressure are controlled to fall within the same ranges as those in the polymerization of the aromatic monovinyl monomer. The vinyl bond content in the conjugated diene monomer unit may also be adjusted using the above-mentioned polar compound as a randomizer during the polymerization of the conjugated diene monomer.

(Coupling step)

In the next step, a polyfunctional coupling agent is added to the solution containing diblock chains and conjugated diene polymer block chains. Thereby, the active ends included in the diblock chains, those included in the conjugated diene polymer block chains, and the polyfunctional coupling agent are reacted, so that three or more chains as branches are bonded through a residue of the polyfunctional coupling agent to form the block copolymer A1. The polyfunctional coupling agent to be used can be those described above. A compound having action to promote the coupling reaction can also be added.

The amount of the polyfunctional coupling agent used is appropriately adjusted according to the number of chains as branches in the block copolymer A1 and the content of the block copolymer A1 in the block copolymer composition. The amount of the polyfunctional coupling agent used is within the range of preferably 0.0001 to 20 mol, more preferably 0.01 to 10 mol, still more preferably 0.02 to 6 mol relative to 1 mol of the organolithium initiator. When the amount of the polyfunctional coupling agent used falls within the ranges above, byproducts of the polymer component other than the block copolymer A1 can be suppressed, and a block copolymer composition containing the target block copolymer A1 can be easily obtained.

Although the appropriate amount of the polyfunctional coupling agent used can be determined by calculation according to the number of chains as branches in the target block copolymer A1 and the content of the block copolymer A1 in the block copolymer composition, preferably, a preliminary experiment is performed to obtain an optimum value because the organolithium initiator or the polyfunctional coupling agent is deactivated in an actual polymerization reaction. A reaction terminator such as methanol can be used, as needed, to adjust the coupling ratio. Furthermore, the diblock chains and the conjugated diene polymer block chains obtained through the polymerization step may be left unreacted by adjusting the amount of the polyfunctional coupling agent used or using the reaction terminator, and may be finally recovered as the diblock copolymer B and the polymer C.

The reaction temperature is preferably 10 to 150°C, more preferably 30 to 130°C, still more preferably 40 to 90°C. The time needed for the reaction varies depending on the conditions, but it is usually within 48 hours, preferably 0.5 to 10 hours.

After the reaction step, the polymer component may be recovered from a solution containing the block copolymer composition containing the block copolymer A1, the optional diblock copolymer B, and the optional polymer C (recovery step). It is sufficient that the recovery thereof is performed according to a conventional method, which is not particularly limited. For example, the recovery thereof can be performed by adding a polymerization terminator such as water, methanol, ethanol, propanol, hydrochloric acid, or citric acid, as needed, after the completion of the reaction, further adding additives as an antioxidant, as needed, and then subjecting the solution to a known method such as direct drying or steam stripping. When the polymer component is recovered as a slurry by steam stripping or the like, preferably, the polymer component is dehydrated into crumbs having a water content of a predetermined value or smaller using any dehydrator such as an extruder-type squeezer, and the crumbs are dried using any dryer such as a band dryer or an expansion extrusion dryer. The block copolymer obtained as described above may be used after it is processed into pellets or the like according to a conventional method.

Thus, the block copolymer composition containing the block copolymer A1 can be produced.

(1-6-2) Method of producing block copolymer composition containing block copolymer A2

Suitable examples of a method of producing the block copolymer composition containing the block copolymer A2 include a production method comprising:

a polymerization step of polymerizing an aromatic monovinyl monomer in a polymerization solvent using an organolithium initiator to obtain a solution containing aromatic monovinyl polymer block chains;
a polymerization step of adding a conjugated diene monomer to the solution containing the aromatic monovinyl polymer block chains, followed by polymerization to obtain diblock chains; and
a coupling step of reacting a polyfunctional coupling agent with the diblock chains.

(Polymerization step)

The polymerization step of polymerizing an aromatic monovinyl monomer in a polymerization solvent using an organolithium initiator to obtain a solution containing aromatic monovinyl polymer block chains can be performed in the same manner as in the corresponding polymerization step in the method of producing the block copolymer composition containing the block copolymer A1, and suitable examples are as described above.

The solution containing aromatic monovinyl polymer block chains can be obtained by polymerizing the aromatic monovinyl monomer in a solvent using an organolithium initiator under such conditions. The aromatic monovinyl polymer block chains obtained through the polymerization usually have active ends. Since the aromatic monovinyl polymer block chains obtained will form the aromatic monovinyl polymer block (Ar) or the aromatic monovinyl polymer block (Ar$^3$), the amount of the monomer used in this polymerization step can be determined according to the weight average molecular weight of the aromatic monovinyl polymer block (Ar) and that of the aromatic monovinyl polymer block (Ar$^3$) .

In the next step, a conjugated diene monomer is added to the resulting solution containing the aromatic vinyl polymer block chains, followed by polymerization. Thereby, a solution containing diblock chains can be obtained. Note that the diblock chains obtained through the polymerization usually have active ends. In the diblock chains obtained, polymer chains which will form the conjugated diene polymer block (D) or the conjugated diene polymer block (D$^3$) are further bonded to the polymer chains which will form the aromatic monovinyl polymer block (Ar) and the aromatic monovinyl polymer block (Ar$^3$). For this reason, the amount of the monomer used in this polymerization step can be determined according to the weight average molecular weight of the conjugated diene polymer block (D) and that of the conjugated diene polymer block (D$^3$). The polymerization reaction temperature, the polymerization time, and the polymerization pressure may be controlled to fall within the same ranges as those in the polymerization of the aromatic monovinyl monomer. The vinyl bond content in the conjugated diene monomer unit may also be adjusted using the above-mentioned polar compound as a randomizer during the polymerization of the conjugated diene monomer.

(Coupling step)

In the next step, a polyfunctional coupling agent is added to the solution containing diblock chains. Thereby, the active ends included in the diblock chains and the polyfunctional coupling agent are reacted, so that three or more chains as branches are bonded through a residue of the polyfunctional coupling agent to form the block copolymer A2. The polyfunctional coupling agent to be used can be those described above. A compound having action to promote the coupling reaction can also be added.

The amount of the polyfunctional coupling agent used is appropriately adjusted according to the number of chains as branches in the block copolymer A2 and the content of the block copolymer A2 in the block copolymer composition. The amount of the polyfunctional coupling agent used is within the range of preferably 0.0001 to 20 mol, more preferably 0.01 to 10 mol, still more preferably 0.02 to 6 mol relative to 1 mol of the organolithium initiator. When the amount of the polyfunctional coupling agent used falls within the ranges above, byproducts of the polymer component other than the block copolymer A2 can be suppressed, and a block copolymer composition containing the target block copolymer A2 can be easily obtained.

Although the appropriate amount of the polyfunctional coupling agent used can be determined by calculation according to the number of chains as branches in the target block copolymer A2 and the content of the block copolymer A2 in the block copolymer composition, preferably, a preliminary experiment is performed to obtain an optimum value because the organolithium initiator or the polyfunctional coupling agent is deactivated in an actual polymerization reaction. A reaction terminator such as methanol can be used, as needed, to adjust the coupling ratio. Furthermore, the diblock chains obtained through the polymerization step may be left unreacted by adjusting the amount of the polyfunctional coupling agent used or using a reaction terminator, and may be finally recovered as the diblock copolymer B.

The conditions for the coupling step can be the same conditions as those in the coupling step in the method of producing the block copolymer composition containing the block copolymer A1, and suitable examples can be as described above.

After the coupling step, the polymer component may be recovered from the solution containing the block copolymer composition containing the block copolymer A2 and the optional diblock copolymer B (recovery step). The conditions for the recovery step can be the same conditions as those in the recovery step in the method of producing the block copolymer composition containing the block copolymer A1, and suitable examples are as described above. The block copolymer obtained as described above may be used after it is processed into pellets or the like according to a conventional method.

Thus, the block copolymer composition containing the block copolymer A2 can be produced.

2. Photopolymerization initiator

The photosensitive composition for pattern formation according to the present invention comprises a photopolymerization initiator in addition to the above-mentioned block copolymer composition.

Examples of the photopolymerization initiator include methylhydroquinone, benzophenone, benzoin, benzoin methyl ether, benzoin ethyl ether, benzoin isopropyl ether, benzoin isobutyl ether, $\alpha$-methylbenzoin, $\alpha$-methylbenzoin methyl ether, $\alpha$-methoxybenzoin methyl ether, benzoin phenyl ether, $\alpha$-t-butylbenzoin, anthraquinone, benzanthraquinone, 2-ethylanthraquinone, 2-chloroanthraquinone, 2,2-dimethoxy-1,2-diphenylethan-1-one, 2,2-diethoxyphenylacetophenone, 2,2-diethoxyacetophenone, pivaloin, phenylbis(2,4,6-trimethylbenzoyl)phosphine oxide, and the like. Among these, preferred are 2,2-dimethoxy-1,2-diphenylethan-1-one and phenylbis(2,4,6-trimethylbenzoyl)phosphine oxide, and more preferred is 2,2-dimethoxy-1,2-diphenylethan-1-one. These may be used alone or in combination.

The content of the photopolymerization initiator is preferably 0.1 to 10 parts by weight, more preferably 0.2 to 5 parts by weight, still more preferably 0.5 to 3 parts by weight relative to 100 parts by weight of the block copolymer composition in the photosensitive composition for pattern formation.

3. Other components

The photosensitive composition for pattern formation according to the present invention may comprise other components in addition to the block copolymer composition and the photopolymerization initiator described above.

The photosensitive composition for pattern formation according to the present invention preferably comprise a photopolymerizable ethylenically unsaturated monomer. Examples of the photopolymerizable ethylenically unsaturated monomer include aromatic vinyl monomers such as styrene, o-methylstyrene, m-methylstyrene, p-methylstyrene, p-tert-butylstyrene, 1,3-dimethylstyrene, vinyltoluene, chlorostyrene, vinylnaphthalene, vinylanthracene, divinylbenzene, and trivinylbenzene; ethylenically unsaturated nitrile monomers such as acrylonitrile and methacrylonitrile; ethylenically unsaturated carboxylic acid ester monomers such as methyl acrylate, ethyl acrylate, propyl acrylate, n-amyl acrylate, isoamyl acrylate, hexyl acrylate, ethylhexyl acrylate, octyl acrylate, glycidyl acrylate, methyl methacrylate, ethyl methacrylate, propyl methacrylate, n-amyl methacrylate, isoamyl methacrylate, hexyl methacrylate, ethylhexyl methacrylate, octyl methacrylate, hydroxyethyl acrylate, hydroxypropyl acrylate, hydroxyethyl methacrylate, hydroxypropyl methacrylate, glycidyl methacrylate, ethylene glycol diacrylate, trimethylolpropane triacrylate, 1,4-butanediol diacrylate, 1,4-butanediol dimethacrylate, propylene glycol diacrylate, 1,6-hexanediol diacrylate, 1,6-hexanediol dimethacrylate, 1,9-nonanediol diacrylate, 1,9-nonanediol dimethacrylate, methoxyethylene glycol acrylate, methoxypropylene glycol methacrylate, methoxyethylene glycol methacrylate, methoxypropylene glycol acrylate, diethyl maleate, and dimethyl itaconate; ethylenically unsaturated glycidyl ethers such as allyl glycidyl ether; conjugated dienes such as 1,3-butadiene, isoprene, chloroprene, and 1,3-pentadiene; ethylenically unsaturated monocarboxylic acids such as acrylic acid and methacrylic acid; ethylenically unsaturated polyvalent carboxylic acids such as maleic acid, fumaric acid, citraconic acid, and itaconic acid; partially esterified products of ethylenically unsaturated polyvalent carboxylic acids, such as monoethyl maleate and monomethyl itaconate; phosphoric acid ester group-containing ethylenically unsaturated monomers such as phosphoric acid ethylene acrylate, phosphoric acid trimethylene acrylate, phosphoric acid propylene acrylate, phosphoric acid tetramethylene acrylate, phosphoric acid (bis)ethylene acrylate, phosphoric acid (bis)trimethylene acrylate, phosphoric acid (bis)tetramethylene acrylate, phosphoric acid diethylene glycol acrylate, phosphoric acid triethylene glycol acrylate, phosphoric acid polyethylene glycol acrylate, phosphoric acid (bis)diethylene glycol acrylate, phosphoric acid (bis)triethylene glycol acrylate, phosphoric acid (bis)polyethylene glycol acrylate, and methacrylates corresponding to these; and the like. Among these, preferred are ethylenically unsaturated carboxylic acid ester monomers, more preferred are 1,9-nonanediol diacrylate and 1,9-nonanediol dimethacrylate, and still more preferred is 1,9-nonanediol diacrylate. These may be used alone or in combination.

The content of the photopolymerizable ethylenically unsaturated monomer is preferably 0.01 to 10 parts by weight, more preferably 0.02 to 5 parts by weight, still more preferably 0.05 to 2 parts by weight, particularly preferably 0.1 to 1 part by weight relative to 100 parts by weight of the block copolymer composition in the photosensitive composition for pattern formation. When the content of the photopolymerizable ethylenically unsaturated monomer falls within the ranges above, the photosensitive composition for pattern formation can have enhanced molding properties and photosensitivity, and a molded body to be obtained can have better balanced levels of wear resistance, flexibility, ink swelling resistance, and mechanical strength.

The photosensitive composition for pattern formation according to the present invention may comprise a plasticizer, a thermal polymerization inhibitor, an antioxidant, an ozone cracking preventer, a dye, a pigment, a filler, an additive having photochromism, a reductant, a relief structure improving drug, a cross-linking agent, a flow improver, a mold release agent, and the like, for example.

The plasticizer is usually used to facilitate production and molding of the photosensitive composition for pattern formation, promote removal of unexposed portions, or adjust the hardness of portions cured by exposure to light. Examples of the plasticizer include hydrocarbon oils such as naphthene oil and paraffin oil; liquid 1,2-polybutadiene, liquid 1,4-polybutadiene, and hydroxides or carboxylated products thereof; liquid acrylonitrile-butadiene copolymers and carboxylated products thereof; liquid styrene-butadiene copolymers and carboxylated products thereof; low molecular weight polystyrene having a molecular weight of 3,000 or less, $\alpha$-methylstyrene-vinyltoluene copolymer, petroleum resins, polyacrylate resins, polyester resins, polyterpene resins, and the like. These may be used alone or in combination. The content of the plasticizer is preferably 0.1 to 50 parts by weight, more preferably 1 to 40 parts by weight, still more preferably 2 to 30 parts by weight relative to 100 parts by weight of the block copolymer composition in the photosensitive composition for pattern formation.

The thermal polymerization inhibitor is used to prevent unintentional thermal polymerization of the photopolymerizable ethylenically unsaturated monomer during preparation of the photosensitive composition for pattern formation.

Examples of the thermal polymerization inhibitor include phenols such as hydroquinone, p-methoxyphenol, p-t-butyl catechol, 2,6-di-t-butyl-p-cresol, and pyrogallol; quinones such as benzoquinone, p-toluquinone, and p-xyloquinone; amines such as phenyl-$\alpha$-naphthylamine; and the like. These may be used alone or in combination. The content of the thermal polymerization inhibitor is preferably 0.1 to 10 parts by weight, more preferably 0.2 to 5 parts by weight relative to 100 parts by weight of the block copolymer composition in the photosensitive composition for pattern formation.

4. Method of producing photosensitive composition for pattern formation

The photosensitive composition for pattern formation can be produced by any method, and for example, can be produced by kneading the above-mentioned block copolymer compositions, the above-mentioned photopolymerization initiator, and other optional components with a kneader, a roll mill, a Banbury, a single or twin screw extruder, or the like. The photosensitive composition for pattern formation according to the present invention is usually molded into a sheet having a desired thickness using a molding machine such as a single or twin screw extruder, a compression molding machine, or a calender molding machine. When a single or twin screw extruder is used, preparation of the photosensitive composition for pattern formation and molding thereof into a molded body in the form of a sheet can be performed at the same time. The photosensitive composition for pattern formation in the form of a sheet can also be produced by dissolving the components constituting the photosensitive composition for pattern formation in an appropriate solvent such as chloroform, carbon tetrachloride, trichloroethane, diethyl ketone, methyl ethyl ketone, benzene, toluene, or tetrahydrofuran, injecting this solution into a mold, and evaporating the solvent.

The thickness of the photosensitive composition for pattern formation in the form of a sheet is usually 0.1 to 20 mm, preferably 1 to 10 mm.

To prevent contamination or damage during storage or operation of the photosensitive composition for pattern formation after molding, a transparent sheet or film made of a resin such as polypropylene, polyethylene, or polyethylene terephthalate, as a base sheet layer or a protective film layer, can be disposed on the surface of the photosensitive composition for pattern formation after molding.

A highly flexible thin coating material layer may be disposed on the surface of the photosensitive composition for pattern formation after molding to reduce the adhesiveness of the surface and reuse the negative film after light irradiation. In this case, after exposure of the photosensitive composition for pattern formation to light is completed, the coating material layer should be removed simultaneously with removal of unexposed portions with a solvent. As the coating material layer, usually, soluble polyamide, cellulose derivatives, or the like are often used.

<Molded body for pattern formation>

A molded body for pattern formation can be obtained using the photosensitive composition for pattern formation. The molded body for pattern formation can be obtained by exposing the photosensitive composition for pattern formation according to the present invention to light.

The molded body for pattern formation is usually produced according to the following steps.

(i) : A multi-layered sheet composed of a protective film, a layer of the photosensitive composition for pattern formation in the form of a sheet, and a base sheet is irradiated with light from the base sheet side to cure the multi-layered sheet until the layer of the photosensitive composition for pattern formation reaches a specific thickness.

(ii): The protective film is peeled off, a negative film is tightly attached, and by irradiation with light having a wavelength of 230 to 450 nm, preferably 350 to 450 nm from above the negative film, the layer of the photosensitive composition for pattern formation is exposed to the light. By this exposure to light, portions of the layer of the photosensitive composition for pattern formation through which light transmits are cured.

(iii): Unexposed portions of the layer of the photosensitive composition for pattern formation, which remain uncured, are removed (development) .

(iv): Since the uncured portions are usually removed with a solvent in (iii), the solvent left in the molded body for pattern formation is dried off.

(v) : If desired, post-exposure to light is performed.

In the development (unexposed portion removal) step in (iii), usually, a solvent is used. Examples of the solvent include aliphatic hydrocarbons and aromatic hydrocarbons such as n-hexane, n-heptane, octane, petroleum ether, naphtha, limonene, terpene, toluene, xylene, ethylbenzene, and isopropyl benzene; ketones such as acetone and methyl ethyl ketone; ethers such as di-n-butyl ether and di-t-butyl ether; esters such as methyl acetate and ethyl acetate; halogenated hydrocarbons such as methylene chloride, chloroform, trichloroethane, tetrachloroethylene, dichlorotetrafluoroethane, and trichlorotrifluoroethane; and the like. These may be used alone or in combination. Furthermore, a desired amount of an alcohol such as methanol, ethanol, isopropanol, or n-butanol can be added to the solvent for use. The development can be accelerated by applying a mechanical force using a brush in the presence of the solvent.

Since the photosensitive composition for pattern formation according to the present invention has high photosensitivity, use of the photosensitive composition for pattern formation according to the present invention enables production of the molded body for pattern formation with high productivity. The photosensitive composition for pattern formation according to the present invention also has sufficient wear resistance, and can provide a molded body having high flexibility and high ink swelling resistance. For this reason, use of the photosensitive composition for pattern formation according to the present invention enables production of a molded body for pattern formation having sufficient wear resistance and having high flexibility and high ink swelling resistance. Use of such a molded body for pattern formation as a flexographic plate (original plate for flexographic printing) enables printing with a large number of repetitions even under severe conditions, and additionally enables flexographic printing with excellent ink transfer during printing and high image quality. For this reason, a molded body for pattern formation formed from the photosensitive composition for pattern formation according to the present invention can be suitably used as a flexographic plate.

A variety of materials such as paper, cardboard, wood materials, metals, polyethylene films, polyethylene sheets, polypropylene films, and polypropylene sheets can be used as base materials for flexographic printing.

The present invention is not limited to the above embodiment. The above embodiment is illustrative, and covers any ones having substantially the same configuration as technical ideas described in CLAIMS of the present invention and having the same effects within the technical scope of the present invention.

EXAMPLES

Hereinafter, the present invention will now be more specifically described by way of Examples and Comparative Examples. In Examples, "parts" and "%" are mass-based unless otherwise specified.

A variety of measurements were performed by the methods below.

[Weight average molecular weight and molecular weight distribution]

High performance liquid chromatography was performed using tetrahydrofuran at a flow rate of 0.35 ml/min as a carrier to determine molecular weights relative to polystyrene standards. The apparatus used was HLC8320 available from Tosoh Corporation provided with three Shodex (Registered trademark) KF-404HQ columns (available from Showa Denko K.K.) connected in series (column temperature: 40°C). The detectors used were a differential refractometer and an ultraviolet detector. For molecular weight determination, calibration was performed at 12 points using standard polystyrenes (500 to 3,000,000) available from Polymer Laboratories Ltd.

[Contents of polymers in block copolymer composition]

The contents of the polymers in the block copolymer composition were determined from the area ratios of peaks corresponding to the polymers (block copolymer A1, block copolymer A2, diblock copolymer B, and polymer C) in a chart obtained by high performance liquid chromatography described above.

[Weight average molecular weight of styrene polymer block in block copolymer]

According to the method described in Rubber Chem. Technol., 45, 1295 (1972), isoprene polymer blocks in a block copolymer were decomposed by reacting the block copolymer with ozone, followed by reduction with lithium aluminum hydride. Specifically, the following procedure was performed. That is, 300 mg of a sample was dissolved in 100 ml of dichloromethane treated with a molecular sieve and placed into a reaction vessel. This reaction vessel was placed in a cooling tank, and was cooled to -25°C. Thereafter, ozone generated with an ozone generator was introduced while oxygen was being flowed at a flow rate of 170 ml/min in the reaction vessel. After 30 minutes from the start of the reaction, by introducing the gas flowing out of the reaction vessel into a potassium iodide aqueous solution, it was confirmed that the reaction was completed. Then, 50 ml of diethyl ether and 470 mg of lithium aluminum hydride were charged into another reaction vessel purged with nitrogen, and a solution reacted with ozone was slowly added dropwise to this reaction vessel while the reaction vessel was being cooled with iced water. The reaction vessel was then placed in a water bath, and was gradually heated to reflux at 40°C for 30 minutes. Subsequently, while the solution was being stirred, diluted hydrochloric acid was added dropwise in small portions to the reaction vessel, and the addition was continued until generation of hydrogen was hardly observed. After this reaction, a solid product formed in the solution was separated through a filter. The solid product was extracted with 100 ml of diethyl ether for 10 minutes. This extracted solution and the filtrate during the separation were combined, and the solvent was distilled off therefrom to obtain a solid sample. The sample thus obtained was measured for weight average molecular weight by the above-mentioned method of measuring the weight average molecular weight, and the value was defined as the weight average molecular weight of the styrene polymer block.

[Weight average molecular weight of isoprene polymer block of block copolymer]

The weight average molecular weight of the isoprene polymer block was determined based on the calculated value obtained by subtracting the weight average molecular weight of the corresponding styrene polymer block from the weight average molecular weight of the block copolymer determined as described above.

[Ratio (($Ar^1$-$D^1$)/$D^2$) of mass of chains as branches in block copolymer Al]

2 mL of the polymer solution before the coupling step was sampled, and was mixed with 1 mL of excess methanol to deactivate the polymerization activity. The resulting sample was analyzed by high performance liquid chromatography, and the ratio (($Ar^1$-$D^1$)/$D^2$) of the mass of chains as branches in the block copolymer A1 was determined from the area ratios of peaks in the obtained chart.

[Ratio (($Mw(D^1)$)/($Mw(D^2)$)) of weight average molecular weight of isoprene polymer block in block copolymer Al]

A sample taken before the coupling step was analyzed by high performance liquid chromatography in the same manner as above, and the weight average molecular weight of $Ar^1$-$D^1$ and that of $D^2$ were determined in the same manner as above. Thereafter, the ratio (($Mw(D^1)$)/($Mw(E^2)$)) of the weight average molecular weight of the isoprene polymer block in the block copolymer A1 was determined by subtracting the weight average molecular weight of the styrene polymer block in the block copolymer A1 determined by the above-mentioned method.

[Average number of branches of block copolymer Al]

The average number of branches of the block copolymer ALL was calculated from the weight average molecular weight of the block copolymer A1, that of $Ar^1$-$D^1$, that of $D^2$, and the ratio (($Ar^1$-$D^1$)/$D^2$) of the mass of chains as branches in the block copolymer A1, which were determined by the above-mentioned method.

[Average number of branches of block copolymer A2]

A sample taken before the coupling step was analyzed by high performance liquid chromatography in the same manner as above, and the weight average molecular weight of Ar-D was determined in the same manner as above. Then, the average number of branches of the block copolymer A2 was calculated from the weight average molecular weight of the block copolymer A2 and that of Ar-D which were determined by the above-mentioned method.

[Styrene unit content in entire block copolymer composition]

The styrene unit content was determined based on measurement by proton NMR.

[Melt index of block copolymer composition]

The melt index was measured according to ASTM D1238 (G condition, 200°C, load: 5 kg).

[Type A hardness of block copolymer composition]

The type A hardness was measured according to JIS K6253 using a durometer hardness tester (type A).

[Molding properties]

Using a twin screw extruder to which a T-die was attached, a photosensitive composition for pattern formation was molded into a sheet having a thickness of 2 mm by melting the photosensitive composition by heating at 150°C, and continuously extruding it. Then, the resulting sheet was visually observed, and was evaluated according to the following criteria:

Good: A sheet having a smooth surface was obtained.
Poor: A sheet having a rough surface (depressions and projections on the surface) was obtained.
Very Poor: Extrusion of the photosensitive composition for pattern formation from the twin screw extruder was impossible.

The conditions for molding the sheet are as follows:

composition processing rate: 25 kg/hr
take-up rate: 1.0 m/min
extruder temperature: adjusted to 140°C at the feed port and 160°C at the T-die
screw: full flight
extruder L/D: 20
T-die: width of 200 mm, lip of 2.5 mm

[Photosensitivity (gel fraction)]

A sheet was prepared in the same method as that in evaluation of the molding properties. The resulting sheet was exposed to light by irradiation with active light beams for 10 minutes using an exposure apparatus (available from JEOL, Ltd., type: JE-A3-SS) to which a 20 W ultraviolet light fluorescent lamp was attached, and was dried for 30 minutes with a hot air dryer at 60°C to obtain an exposed sheet. The exposed sheet was cut out into a sample of about 500 mg. The weight (x) of the sample before a test was weighed. The sheet after weighed was immersed in 100 ml of ethyl acetate at room temperature for 3 days. Thereafter, insolubles were filtered through a metal mesh of 80 mesh, and were air dried for 15 hours under normal temperature, then dried at 100°C for 2 hours, and were cooled under normal temperature. Thereafter, the weight (y) of the sample after the test was measured, and the gel fraction was calculated from the following expression. A higher gel fraction indicates higher photosensitivity.

$$\text{gel fraction (\%)} = (y)/(x) \times 100$$

[Tensile elastic modulus of sheet]

An exposed sheet was obtained by the same method as that in evaluation of the photosensitivity (gel fraction). The exposed sheet was measured for tensile elastic modulus. The measurement procedure is as described below. Using Tensilon universal tester RTC-1210 available from ORIENTEC CO., LTD., the sheet was stretched to 100% at a stretching rate of 300 mm/min. In this process, the tensile stress of the sheet when stretched to 100% was measured, and the tensile elastic modulus of the sheet when stretched to 100% was determined. The tensile elastic moduli in two directions, i.e., the tensile elastic modulus in a melt flow direction during molding and that in a melt flow vertical direction during molding were measured, and the average of the measured values in the two directions was determined, and was defined as the tensile elastic modulus of the sheet when stretched to 100%.

[Permanent set of sheet]

An exposed sheet was obtained by the same method as that in evaluation of the photosensitivity (gel fraction). Using the above-mentioned Tensilon universal tester, the exposed sheet was measured for permanent set according to ASTM 412. Specifically, Die A was used as the sample shape, and the sheet was stretched at an elongation percentage of 200% with the gauge length before stretching of 40 mm. The sheet was held as it was for 10 minutes, was rapidly contracted without rebounding, and was left to stand for 10 minutes. Thereafter, the gauge length was measured, and the permanent set was determined based on the expressions below. The permanent set in two directions, i.e., the permanent set in a melt flow direction during molding and that in a melt flow vertical direction during molding were measured, and the average of the measured values in the two directions was determined, and was defined as the permanent set. A smaller permanent set indicates higher rubber elasticity and higher flexibility.

$$\text{permanent set (\%)} = (L1-L0)/L0 \times 100$$

L0: gauge length (mm) before the sheet is stretched
L1: gauge length (mm) after the sheet is contracted, and left to stand for 10 minutes

[Wear resistance of sheet]

An exposed sheet was obtained by the same method as that in evaluation of the photosensitivity (gel fraction).

In the next step, using a HEIDON wear tester (available from Shinto Scientific Co., Ltd.), the exposed sheet and #1000 water-resistant paper were subjected to reciprocal friction under a load of 100 g at a rate of 6000 mm/sec, and the wear amount of the sheet surface after 1000 cycles was measured. This index is expressed by an index where the value in Comparative Example 1 is regarded as 100. A greater index indicates higher wear resistance.

[Ink swelling resistance of sheet]

An exposed sheet was obtained by the same method as that in evaluation of the photosensitivity (gel fraction). In the next step, the exposed sheet was placed in isopropyl alcohol, and was extracted after 60 minutes. After excess isopropyl alcohol was wiped off, the sheet weight after the test was measured. The ratio of the weights before and after the test (sheet weight after test/sheet weight before test) was calculated, and was defined as the index for the ink swelling resistance. An index closer to 100% indicates higher ink swelling resistance.

[Production Example 1]

Using a 2-liter pressure-resistant reactor, in which 400 g of a mixed solvent of n-butane and cyclohexane in a proportion of 30/70, 0.07 mmol of tetramethylethylenediamine, and 2.25 mmol of n-butyllithium as an initiator were present, 22 g of styrene was added, and was polymerized at 30°C for 1 hour. Subsequently, 78 g of isoprene was added, and was polymerized for about one and a half hours while the temperature was being controlled by reflux cooling such that the reaction temperature fell within the range from 50°C to 60°C. In the next step, divinylbenzene (DVB) as a coupling agent was added in an amount of 4-fold equivalent relative to the total amount of n-butyllithium, and a coupling reaction was performed for 2 hours. Thereafter, 1 ml of methanol as a polymerization terminator and 0.05 g of 2,6-di-tert-butyl-p-cresol as an antioxidant were added to and mixed well with the reaction mixture, and the resulting mixed solution was added dropwise in small portions to hot water heated to 85 to 95°C to vaporize the solvent. The resulting polymer was ground, followed by drying with hot air at 85°C to obtain a block copolymer composition. The resulting block copolymer composition was measured as described above. The results are shown in Table 1.

[Production Example 2]

A block copolymer composition was obtained in the same manner as in Production Example 1 except that the amounts of styrene and isoprene added were varied as shown in Table 1. The resulting block copolymer composition was measured as described above. The results are shown in Table 1.

[Production Example 3]

Using a 2-liter pressure-resistant reactor, in which 400 g of a mixed solvent of n-butane and cyclohexane in a proportion of 30/70, 0.07 mmol of tetramethylethylenediamine, and 1.75 mmol of n-butyllithium as an initiator were present, 22 g of styrene was added, and was polymerized at 30°C for 1 hour. Subsequently, 0.75 mmol of n-butyllithium and 78 g of isoprene were added, followed by polymerization for about one and a half hours while the temperature was being controlled by reflux cooling such that the reaction temperature fell within the range from 50°C to 60°C. In the next step, divinylbenzene (DVB) as a coupling agent was added in an amount of 4-fold equivalent relative to the total amount of n-butyllithium, and a coupling reaction was performed for 2 hours. Thereafter, 1 ml of methanol as a polymerization terminator and 0.05 g of 2,6-di-tert-butyl-p-cresol as an antioxidant were added to and mixed well with the reaction mixture, and the resulting mixed solution was added dropwise in small portions to hot water heated to 85 to 95°C to vaporize the solvent. The resulting polymer was ground, followed by drying with hot air at 85°C to obtain a block copolymer composition. The resulting block copolymer composition was measured as described above. The results are shown in Table 1.

[Production Examples 4 to 5]

A block copolymer composition was obtained in the same manner as in Production Example 3 except that the amounts of n-butyllithium, styrene, and isoprene added were varied as shown in Table 1. The resulting block copolymer composition was measured as described above. The results are shown in Table 1.

[Production Example 6]

Using a 2-liter pressure-resistant reactor, in which 400 g of a mixed solvent of n-butane and cyclohexane in a proportion of 30/70, 0.07 mmol of tetramethylethylenediamine, and 1.25 mmol of n-butyllithium as an initiator were present, 16 g of styrene was added, and was polymerized at 30°C for 1 hour. Thereafter, 28 g of isoprene was added, and was polymerized for about one and a half hours while the temperature was being controlled by reflux cooling such that the reaction temperature fell within the range from 50°C to 60°C. Subsequently, 1.25 mmol of n-butyllithium and 56 g of isoprene were added, and polymerization was performed for about one and an half hours while the temperature was being controlled by reflux cooling such that the reaction temperature fell within the range from 50°C to 60°C. In the next step, divinylbenzene (DVB) as a coupling agent was added in an amount of 4-fold equivalent relative to the total amount of n-butyllithium, and a coupling reaction was performed for 2 hours. Thereafter, 1 ml of methanol as a polymerization terminator and 0.05 g of 2,6-di-tert-butyl-p-cresol as an antioxidant were added to and mixed well with the reaction mixture, and the resulting mixed solution was added dropwise in small portions to hot water heated to 85 to 95°C to vaporize the solvent. The resulting polymer was ground, followed by drying with hot air at 85°C to obtain a block copolymer composition. The resulting block copolymer composition was measured as described above. The results are shown in Table 1.

[Table 1]

Table 1

| | Production Example 1 | Production Example 2 | Production Example 3 | Production Example 4 | Production Example 5 | Production Example 6 |
|---|---|---|---|---|---|---|
| Structure having three or more branches | Present | Present | Present | Present | Present | Present |
| Polymerization at 1st stage | | | | | | |
| n-Butyllithium (mmol) | 2.25 | 2.25 | 1.75 | 1.5 | 1.0 | 1.25 |
| Monomer | Styrene | Styrene | Styrene | Styrene | Styrene | Styrene |
| Amount added (g) | 22 | 16 | 22 | 16 | 10 | 16 |
| Monomer | Isoprene | Isoprene | - | - | - | Isoprene |
| Amount added (g) | 78 | 84 | - | - | - | 28 |
| Polymerization at 2nd stage | | | | | | |
| n-Butyllithium (mmol) | - | - | 0.75 | 0.5 | 2.33 | 1.25 |
| Monomer | - | - | Is oprene | Isoprene | Isoprene | Isoprene |
| Amount added (g) | - | - | 78 | 84 | 90 | 56 |
| Coupling agent | | | | | | |
| Type | DVB | DVB | DVB | DVB | DVB | DVB |
| Amount added (Coupling agent (mol)/ total n-Butyllithium (mol)) | 4 | 4 | 4 | 4 | 4 | 4 |
| Physical properties of polymers | | | | | | |
| Block copolymer A1 or A2 | | | | | | |
| Type | A2 | A2 | A1 | A1 | A1 | A1 |

(continued)

| Physical properties of polymers | | | | | | |
|---|---|---|---|---|---|---|
| Block copolymer A1 or A2 | | | | | | |
| | Molecular weight distribution (Mw/Mn) | 1.1 | 1.1 | 1.1 | 1.10 | 1.11 | 1.10 |
| | Content (%) in composition | 93 | 95 | 95 | 94 | 95 | 94 |
| | $(Ar^1\text{-}D^1)/D^2$ (mass/ mass) | - | - | 1.0/0.30 | 1.0/0.27 | 1.0/1.70 | 1.0/0.40 |
| | $(Mw(D^1))/ (Mw(D^2))$ | - | - | 1.0/1.0 | 1.0/1.0 | 1.0/1.0 | 1.0/0.5 |
| Weight average molecular weight (Mw) $((\times 10^3)$ g/mol) | | 514 | 557 | 452 | 581 | 386 | 449 |
| | Average number of branches | 7.3 | 7.2 | 6.5 | 7.6 | 7.7 | 6.1 |
| Block copolymer B | | | | | | |
| | Molecular weight distribution (Mw/Mn) | 1.01 | 1.01 | 1.01 | 1.01 | 1.01 | 1.02 |
| | Content (%) in composition | 5 | 4 | 4 | 5 | 2 | 3 |
| Block copolymer C | | | | | | |
| | Molecular weight distribution (Mw/Mn) | 1.01 | 1.01 | 1.01 | 1.01 | 1.02 | 1.02 |
| | Content (%) in composition | 2 | 1 | 1 | 1 | 3 | 3 |
| Block copolymer composition | | | | | | |
| | Total styrene content (%) | 22 | 16 | 22 | 16 | 10 | 16 |
| Weight average molecular weight (Mw) $((\times 10^3)$ g/mol) | | 504 | 546 | 433 | 567 | 336 | 441 |
| | Melt index (g/10min) | 7 | 8 | 10 | 12 | 20 | 14 |
| | Type A hardness | 48 | 44 | 47 | 42 | 37 | 43 |

[Production Example 7]

A block copolymer composition was obtained in the same manner as in Production Example 1 except that the amount of n-butyllithium added and the amount and type of the coupling agent added were varied as shown in Table 2. The resulting block copolymer composition was measured as described above. The results are shown in Table 2.

[Production Example 8]

Using a 2-liter pressure-resistant reactor, in which 400 g of a mixed solvent of n-butane and cyclohexane in a proportion of 30/70, 0.07 mmol of tetramethylethylenediamine, and 0.63 mmol of n-butyllithium as an initiator were present, 3 g of styrene was added, and was polymerized at 30°C for 1 hour. Subsequently, 0.63 mmol of n-butyllithium was added, and then 7 g of styrene was added, and polymerized at 30°C for 1 hour. Thereafter, 90 g of isoprene was added, and was polymerized for about one and a half hours while the temperature was being controlled by reflux cooling such that the reaction temperature fell within the range from 50°C to 60°C. In the next step, divinylbenzene (DVB) as a coupling agent was added in an amount of 4-fold equivalent relative to the total amount of n-butyllithium, and a coupling reaction was performed for 2 hours. Thereafter, 1 ml of methanol as a polymerization terminator and 0.05 g of 2,6-di-tert-butyl-p-cresol as an antioxidant were added to and mixed well with the reaction mixture, and the resulting mixed solution was added dropwise in small portions to hot water heated to 85 to 95°C to vaporize the solvent. The resulting polymer was ground, followed by drying with hot air at 85°C to obtain a block copolymer composition. The resulting block copolymer composition was measured as described above. The results are shown in Table 2.

[Table 2]

Table 2

| | | Production Example 7 | Production Example 8 |
|---|---|---|---|
| Structure having three or more branches | | Present | Present |
| Polymerization at 1st stage | | | |
| | n-Butyllithium (mmol) | 1.82 | 0.63 |
| | Monomer | Styrene | Styrene |
| | Amount added (g) | 22 | 3 |
| | Monomer | Isoprene | - |
| | Amount added (g) | 78 | - |
| Polymerization at 2nd stage | | | |
| | n-Butyllithium (mmol) | - | 0.63 |
| | Monomer | - | Styrene |
| | Amount added (g) | - | 7 |
| | Monomer | - | Isoprene |
| | Amount added (g) | - | 90 |
| Coupling agent | | | |
| | Type | Tetramethoxysilane | DVB |
| Amount added (Coupling agent (mol)/total n-Butyllithium (mol)) | | 0.25 | 4 |
| Physical properties of polymers | | | |
| Block copolymer A1 or A2 | | | |
| | Type | A1 | A1 |
| | Molecular weight distribution (Mw/Mn) | 1.02 | 1.16 |

(continued)

| Physical properties of polymers | | |
|---|---|---|
| Block copolymer A1 or A2 | | |
| Content (%) in composition | 83 | 92 |
| $(Ar^1\text{-}D^1)/D^2$ (mass/mass) | - | - |
| $(Mw(D^1))/(Mw(D^2))$ | - | - |
| Weight average molecular weight (Mw) (($\times$10^3) g/mol) | 265 | 1010 |
| Average number of branches | 3.4 | 8.5 |
| Block copolymer B | | |
| Molecular weight distribution (Mw/Mn) | 1.01 | 1.18 |
| Content (%) in composition | 17 | 4 |
| Block copolymer C | | |
| Molecular weight distribution (Mw/Mn) | - | - |
| Content (%) in composition | - | - |
| Physical properties of block copolymer composition | | |
| Total styrene content (%) | 22 | 10 |
| Weight average molecular weight (Mw) (($\times$10^3) g/mol) | 234 | 968 |
| Melt index (g/10min) | 9 | 0.1> |
| Type A hardness | 48 | Not measurable |

[Example 1 ]

Using a kneader-kneader, 100 parts of the block copolymer composition obtained in Production Example 1, 10 parts of liquid polybutadiene (NISSO-PB-B-2000: available from NIPPON SODA CO., LTD.), and 1 part of 2,6-di-t-butyl-p-cresol were kneaded at 170°C. Subsequently, the kneading temperature was lowered to 130°C, and 0.25 parts of 1,9-nonanediol diacrylate and 1 part of 2,2-dimethoxy-1,2-diphenylethan-1-one were added and kneaded to obtain a photosensitive composition for pattern formation. The resulting photosensitive composition for pattern formation were measured for molding properties, photosensitive (gel fraction), tensile elastic modulus of the sheet, permanent set of the sheet, wear resistance of the sheet, and ink swelling resistance of the sheet. The results are shown in Table 3.

[Examples 2 to 6, Comparative Examples 1 to 3]

Photosensitive compositions for pattern formation were obtained in the same manner as in Example 1 except that the type of the block copolymer composition was changed as shown in Table 3 and the amount of 1,9-nonanediol diacrylate added was varied as shown in Table 3. The resulting photosensitive compositions for pattern formation were measured in the same manner as in Example 1. The results are shown in Table 3.

[Table 3]

Table 3

| | | Example 1 | Example 2 | Example 3 | Example 4 | Example 5 | Example 6 | Comp. Ex. 1 | Comp. Ex. 2 | Comp. Ex. 3 |
|---|---|---|---|---|---|---|---|---|---|---|
| Type of block copolymer composition | | Production Example 1 | Production Example 2 | Production Example 3 | Production Example 4 | Production Example 5 | Production Example 6 | Production Example 7 | Production Example 7 | Production Example 8 |
| Formulation of photosensitive composition for pattern formation | | | | | | | | | | |
| Block copolymer composition | (Parts) | 100 | 100 | 100 | 100 | 100 | 100 | 100 | 100 | 100 |
| Liquid polybutadiene | (Parts) | 10 | 10 | 10 | 10 | 10 | 10 | 10 | 10 | 10 |
| 2,6-Di-t-butyl-p-cresol | (Parts) | 1 | 1 | 1 | 1 | 1 | 1 | 1 | 1 | 1 |
| 1,9-Nonanediol diacrylate | (Parts) | 0.25 | 0.25 | 0.25 | 0.25 | 0.25 | 0.25 | 0.25 | 5 | 0.25 |
| 2,2-Dimethoxy-1,2-diphenylethan-1-one | (Parts) | 1 | 1 | 1 | 1 | 1 | 1 | 1 | 1 | 1 |
| Evaluations | | | | | | | | | | |
| Molding properties | | Good | Good | Good | Good | Good | Good | Good | Poor | Very Poor |
| Photosensitivity (gel fraction) | (%) | 80 | 82 | 81 | 80 | 83 | 81 | 35 | 67 | - |
| Tensile elastic modulus of sheet | (MPa) | 0.8 | 0.7 | 0.8 | 0.7 | 0.5 | 0.7 | 0.7 | 0.7 | - |
| Permanent set of sheet | (%) | 4 | 2 | 6 | 4 | 6 | 4 | 15 | 8 | - |
| Wear resistance of sheet | | 120 | 118 | 119 | 116 | 110 | 119 | 100 | 110 | - |
| Ink swelling resistance of sheet | (%) | 101 | 102 | 101 | 102 | 104 | 102 | 120 | 105 | - |

Table 3 shows that the photosensitive compositions for pattern formation each containing a block copolymer composition and a photopolymerization initiator wherein the block copolymer composition contained the block copolymer A1 or the block copolymer A2 and the weight average molecular weight (Mw) of the entire block copolymer composition was 300,000 to 800,000 had high photosensitivity (Examples 1 to 6). Because the sheets obtained using the photosensitive compositions for pattern formation had sufficient wear resistance and had high flexibility and ink swelling resistance, the photosensitive compositions for pattern formation can provide molded bodies having sufficient wear resistance and having high flexibility and ink swelling resistance (Examples 1 to 6).

In contrast, when the weight average molecular weight (Mw) of the entire block copolymer composition was extremely small, the sheets obtained using the photosensitive compositions for pattern formation had poor flexibility, and further, the processability of the photosensitive composition for pattern formation and the wear resistance and ink swelling resistance of the sheet obtained therefrom were not satisfied at the same time (Comparative Examples 1 and 2).

When the weight average molecular weight (Mw) of the entire block copolymer composition was extremely large, the sheet could not be obtained (Comparative Example 3).

**Claims**

1. A photosensitive composition for pattern formation comprising a block copolymer composition and a photopolymerization initiator,

   wherein the block copolymer composition contains a block copolymer A1 represented by General Formula (1) below or a block copolymer A2 represented by General Formula (2) below, and
   the weight average molecular weight (Mw) of the entire block copolymer composition is 300,000 to 800,000:

   $$(Ar^1\text{-}D^1)_m X^1 (D^2)_n \qquad (1)$$

   where in General Formula (1), $Ar^1$ is an aromatic monovinyl polymer block, $D^1$ and $D^2$ each represent a conjugated diene polymer block, m is an integer of 1 or more, n is an integer of 1 or more, m+n is an integer of 3 or more, and $X^1$ is a residue of a polyfunctional coupling agent;

   $$(Ar\text{-}D)_p X \qquad (2)$$

   where in General Formula (2), Ar is an aromatic monovinyl polymer block, D is a conjugated diene polymer block, p is an integer of 3 or more, and X is a residue of a polyfunctional coupling agent.

2. The photosensitive composition for pattern formation according to claim 1, wherein the molecular weight distribution (Mw/Mn) of the block copolymer A1 or the block copolymer A2 is 1.40 or less, and
   the total content of the block copolymer A1 and the block copolymer A2 in the block copolymer composition is 10% by mass or more.

3. The photosensitive composition for pattern formation according to claim 1 or 2, wherein the block copolymer composition further contains a diblock copolymer B represented by General Formula (3) below or a polymer C represented by General Formula (4) below,

   the molecular weight distribution (Mw/Mn) of the diblock copolymer B or the polymer C is 1.20 or less,
   the total content of the diblock copolymer B and the polymer C in the block copolymer composition is 60% by mass or less,
   the content of aromatic monovinyl monomer units in the block copolymer composition is 5 to 40% by mass, and
   the block copolymer composition has a melt index of 0.5 to 50 g/10 min, the melt index being measured according to ASTM D1238 (G condition, 200°C, load: 5 kg):

   $$Ar^3\text{-}D^3 \qquad (3)$$

   $$D^4 \qquad (4)$$

   where in General Formulae (3) and (4), $Ar^3$ is an aromatic monovinyl polymer block, and $D^3$ and $D^4$ each represent a conjugated diene polymer block.

4. The photosensitive composition for pattern formation according to any one of claims 1 to 3, wherein the block copolymer composition contains the block copolymer A1.

5. The photosensitive composition for pattern formation according to any one of claims 1 to 4, wherein the block copolymer composition contains the block copolymer A1, and
the ratio (($Ar^1$-$D^1$)/$D^2$) of the mass of a chain as a branch represented by $Ar^1$-$D^1$ to that of a chain as a branch represented by $D^2$ in the block copolymer A1 is 1.0/0.15 to 1.0/2.00.

6. The photosensitive composition for pattern formation according to any one of claims 1 to 5, wherein the block copolymer composition contains the block copolymer A1, and
the ratio (($Mw(D^1)$)/($Mw(D^2)$)) of the weight average molecular weight ($Mw(D^1)$) of the conjugated diene polymer block $D^1$ in the chain as a branch represented by $Ar^1$-$D^1$ to the weight average molecular weight ($Mw(D^2)$) of the chain as a branch represented by $D^2$ in the block copolymer A1 is 1.0/0.3 to 1.0/1.1.

7. The photosensitive composition for pattern formation according to any one of claims 1 to 6, wherein the polyfunctional coupling agent is a compound having two or more radical polymerizable groups in its molecule.

8. The photosensitive composition for pattern formation according to any one of claims 1 to 7, wherein the polyfunctional coupling agent is divinylbenzene.

9. The photosensitive composition for pattern formation according to any one of claims 1 to 8, further comprising a photopolymerizable ethylenically unsaturated monomer.

10. A flexographic plate formed from the photosensitive composition for pattern formation according to any one of claims 1 to 9.

| INTERNATIONAL SEARCH REPORT | International application No. |
|---|---|
| | **PCT/JP2022/031104** |

**A.  CLASSIFICATION OF SUBJECT MATTER**

*G03F 7/033*(2006.01)i; *B41N 1/12*(2006.01)i; *C08F 297/04*(2006.01)i; *G03F 7/00*(2006.01)i; *G03F 7/075*(2006.01)i
FI:   G03F7/033; C08F297/04; G03F7/075 501; G03F7/00 502; B41N1/12

According to International Patent Classification (IPC) or to both national classification and IPC

**B.  FIELDS SEARCHED**

Minimum documentation searched (classification system followed by classification symbols)

G03F7/033; B41N1/12; C08F297/04; G03F7/00; G03F7/075

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
|---|---|---|
| X | JP 2007-279422 A (ASAHI KASEI CHEMICALS CORP) 25 October 2007 (2007-10-25) claims, examples | 1-6, 9-10 |
| Y | | 7-8 |
| X | JP 2006-284615 A (NIPPON ZEON CO LTD) 19 October 2006 (2006-10-19) claims, examples | 1-10 |
| Y | | 7-8 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **05 October 2022** | **18 October 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/031104**

| Patent document cited in search report | | | Publication date (day/month/year) | Patent family member(s) | Publication date (day/month/year) |
|---|---|---|---|---|---|
| JP | 2007-279422 | A | 25 October 2007 | (Family: none) | |
| JP | 2006-284615 | A | 19 October 2006 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021047322 A

**Non-patent literature cited in the description**

- *Rubber Chem. Technol.,* 1972, vol. 45, 1295